# EUROPEAN PATENT APPLICATION

(11) **EP 1 119 037 A2**
(43) Date of publication of application: **25.07.2001**
(21) Application number: 01103688.6
(22) Date of filing: 25.07.1997
(51) Int. Cl.: H01L 21/56

(54) **Semiconductor device and method of manufacturing thereof**

(30) Priority: 20.08.1996 JP 21827496; 21.02.1997 JP 3737697
(62) Divisional of application: 97933026.3
(71) Applicant: Hitachi, Ltd., Chiyoda-ku, Tokyo 101-8010 (JP)
(72) Inventor: Tsunoda, Shigeharu, Fujisawa-shi, Kanagawa 251 (JP); Saeki, Junichi, Yokohama-shi, Kanagawa 245 (JP); Hozoji, Hiroshi, Totsuka-ku, Yokohama-shi, Kanagawa 244 (JP); Serizawa, Koji, Fujisawa-shi, Kanagawa 252 (JP); Ogawa, Toshio, Hitachinaka-shi, Ibaraki 312 (JP); Kumazawa, Tetsuo, Nihari-gun, Ibaraki 300-01 (JP)
(74) Representative: Altenburg, Udo, Dipl.-Phys.

(57) **Abstract**

A purpose of the present invention is to provide a module structure and a manufacturing method which is preferable for manufacturing a semiconductor plastic package, and in particular, a power semiconductor module.

The above-mentioned purpose can be attained by using a board 6 with positioning holes, on which components 1 including a power semiconductor element, a electric circuit board 4, a heat spreader 5, a power supply terminal 2 and a control signal terminal are mounted, and molding the board with resin 7, thereby it is possible to manufacture a power semiconductor module of a resin-molded type at a low cost.

## Description

### TECHNICAL FIELD

The present invention relates to a semiconductor device such as a power semiconductor module, and also relates to a method of manufacturing thereof.

### PRIOR ART

A conventionally known power module (which will be hereinbelow denoted "power module"), has been manufactured by the steps of encasing a board on which components such as a power semiconductor device and a heat spreader are mounted, in a package case 60, and casting and curing silicone gel and epoxy resin in the package casing 60.

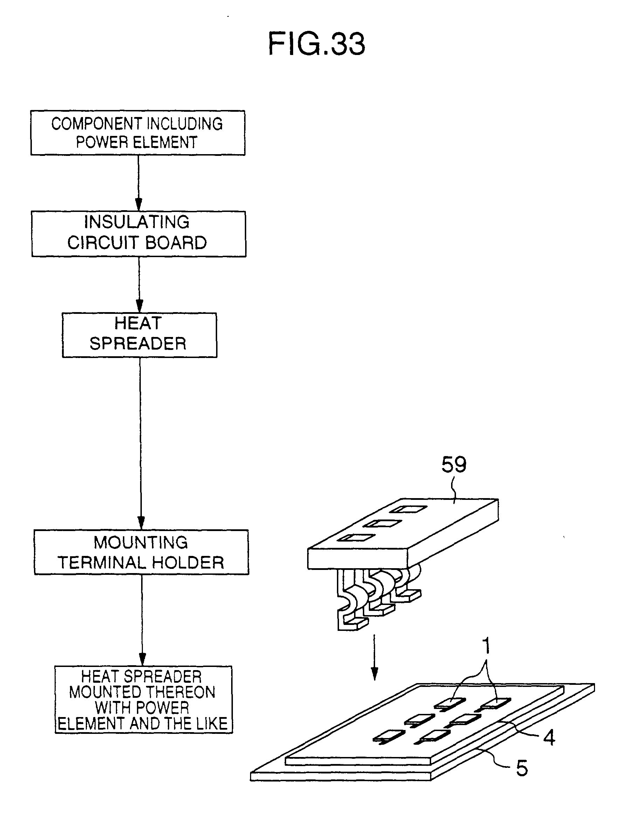

Explanation will be hereinbelow made of a process of manufacturing a conventional power semiconductor module, as an example, with reference to Figs. 33 to 36.

Fig. 33 is a view which shows a process of mounting components of the power module, onto a heat spreader.

That is, an insulating circuit board 4 is joined onto the heat spreader 5, and components 1 such as a power semiconductor element, and a terminal block 8 serving as external connection terminals are mounted on the circuit board 4. These components 1 mounted on the circuit board 4 are connected respectively to predetermined terminals by means of metal wires (which are not shown) so as to form an electric circuit. Further, the terminal block 59 is connected to the electric circuit on the insulating circuit board by means of metal wires so as to establish an electric circuit for the entire power module. As to the metal wires, aluminum wires or the like are used. In this arrangement, the terminal block 59 is projected upright from the insulating circuit board 4. Accordingly, the heat spreader 5c incorporating a semiconductor component is completed.

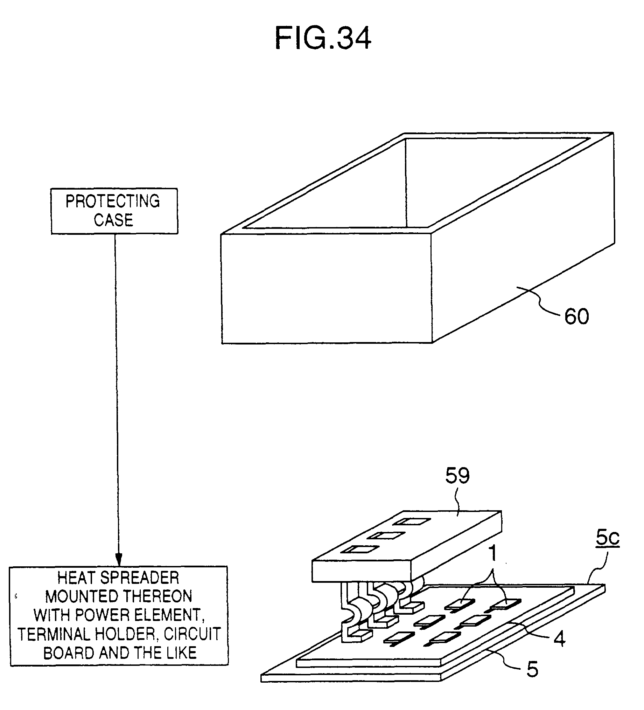

Referring to Fig. 34 which is a view which shows a process of setting the package case onto the heat spreader 5, the heat-spreader 5c mounted thereon with semiconductor components are inserted in the package case 60 which is bonded or welded to the peripheral part of the heat-spreader 5 so as to be integrally incorporated with each other.

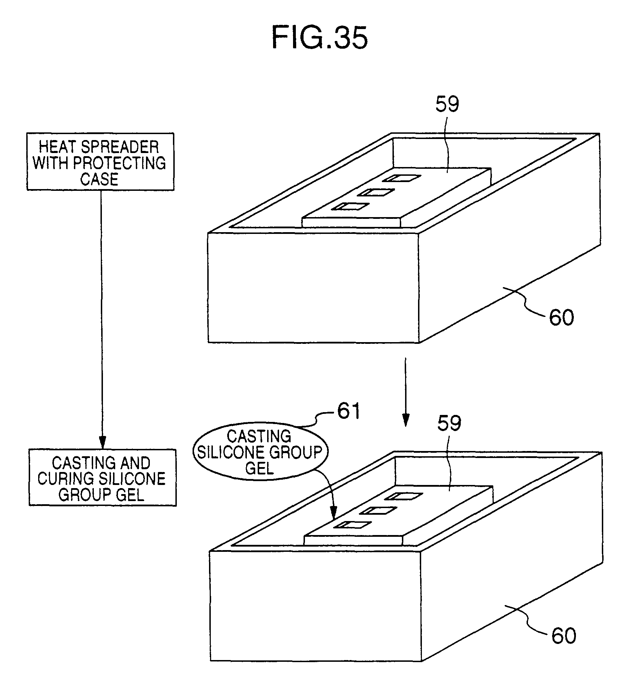

Referring to Fig. 35 which is a view for explaining a process of casting silicone group resin into the package case 59, a silicone group gel 61 is cast in the package case 59 up to a level with which the aluminum wires are buried therein, and is then heated for curing.

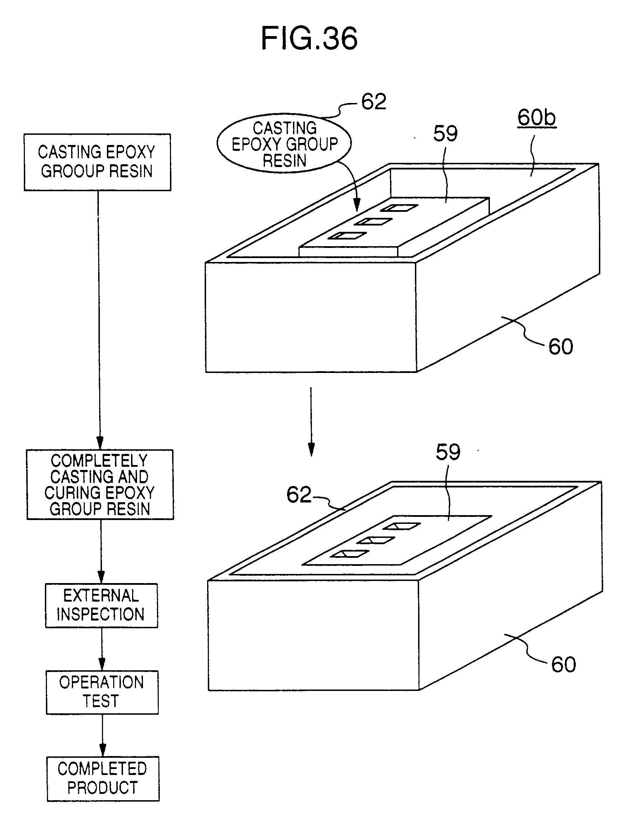

Referring to Fig. 36 which is a view for explaining a process including the steps of casting epoxy group resin so as to complete the semiconductor module, the epoxy resin 62 is cast in the package case 69 over the part 60b in which the silicone group gel 61 has been cast and cured by heating, and is heated for curing so as to complete the process of casting resin.

After the cast resin is cured, the power module is completed through the visual inspection and the operation test thereof. That is, the conventional power module has been manufactured by encasing a structure in which external terminals (a terminal block) are directed vertically, in a protecting case and by casting molding resin thereinto.

The conventional manufacturing method using molding resin has inevitably required the attachment of a protecting case and the like since the molding resin is used, and accordingly, the manufacturing steps thereof have been complicated. Further, due to the use of molding resin, the time for curing the molding resin becomes longer, and accordingly, the continuity among the steps in the conventional power module manufacturing method has been restricted. Thus, there has been a problem in view of the cost thereof.

Thus, the inventors concentrates their consideration onto a manufacturing method in which a structure having external connection terminals directed vertically is manufactured without using molding resin.

A transfer molding process disclosed in Japanese Laid-Open Patent No. H5-226575 is one of methods of manufacturing a power module without using molding resin. In this transfer molding method, components of a power module are sealed by resin with the use of a molding tool. This transfer molding process is preferable for obtaining a continuity among processing steps, thereby it is possible to aim at enhancing the mass productivity so as to lower the manufacturing cost thereof.

However, in general, in the conventional manufacturing method using a transfer molding process, external connection terminals are horizontally arranged on the surface of a heat spreader which is one of the components of a power module to be manufactured, and are then clamped between the upper and lower molding tools before molding. However, no consideration has been made as to a method of molding a non-molded part of the external connection terminals vertically arranged, the provision of which is an object of the present invention.

That is, in the case of transfer-molding external connection terminals vertically arranged, the provision of which is an object of the present invention, the external connection terminals are arranged at a position where they are substantially orthogonal to the opening and closing direction of the molding tool, and accordingly, a clamping pressure for longitudinally fastening the molding tool cannot be directly used as a force for crosswise clamping the external connection terminals.

Should the external connection terminals be unable to be clamped crosswise, the resin molding would be made, leaving gaps between the external connection terminals and the recess in the molding tool, in which the external connection terminals are fitted, causing formation of resin flashes. On the contrary, the near the dimensions of the recess in the molding tool to those of the external connection terminals in order to prevent formation of the above-mentioned gaps, the harder the absorption of dimensional errors of the external connection terminals would be. Thus, there has been raised a problem of impossibility of stably carrying out the transfer-molding, or the like.

Meanwhile, in the case of a structure in which external connection terminals are laid on an surface of a conventional heat spreader, in parallel therewith, a distance between an unmolded parts of the external connection terminals and the heat spreader is short, and accordingly, electric discharging possibly occur therebeteween, resulting in a possibility of breakage of the module. In particular, in a large capacity power module having a high calorific value which requires a heat spreader and heat radiation fins making contact with the heat spreader, the external connection terminals should be set on the heat spreader (alternatively, the heat insulating circuit board), so as to be perpendicular thereto.

### OBJECTS OF THE INVENTION

A first object of the present invention is to establish such a technology that external connection terminals arranged vertically can be transfer-molded so as to provide a method of manufacturing a semiconductor device in which external connection terminals arranged vertically are resin-molded with a high degree of reliability, and the thus manufactured semiconductor device.

Further, there have in general been presented external connection terminals for power modules, having a fast-on type for pin-insertion connection and a receptor for screw fastening, and accordingly, the resin molding of the power module has to be adapted appropriately for the respective types.

A second object of the present invention is to provide a method of stably manufacturing a semiconductor device in which external connection terminals are arranged so as to be substantially vertical with the use of resin molding, and the thus manufactured semiconductor device which can be adapted for the receptor for screw fastening.

### SUMMARY OF THE INVENTION

In order to achieve the first object of the present invention, there is provided a method of manufacturing a semiconductor device, comprising the steps of setting an external connection terminal on a electric circuit board on which a predetermined electric circuit is formed, in a substantially vertical posture, the external connection terminal being electrically connected to the electric circuit, positionally aligning the electric circuit board so that a part of the external connection terminal is fitted in a recess formed in an upper or a lower half of a molding tool at a predetermined position, through the intermediary of an auxiliary member, and casting resin into the molding tool so as to carry out transfer-molding.

With this arrangement, there is provided a transfer-molded semiconductor device in which the external connection terminal electrically connected to the electric circuit is arranged in a substantially vertical posture on the electric circuit board on which the electric circuit is formed.

It is noted here that the vertical direction is a direction in which the external connection terminal is arranged being directed from the electric circuit board to the lower or upper half of the molding tool, and the terminal can include a structure which is not vertical, such as a structure for absorbing a mechanical strength, in the intermediary of the connection terminals with no problem.

With this arrangement in which the external connection terminal arranged vertically is fitted in the recess of the upper or lower half of the molding tool through the intermediary of the auxiliary member, a vertical fastening force of the molding tool can be converted into a force for clamping the external connection terminal by means of the auxiliary member, and accordingly, it is possible to prevent formation of resin flashes and to carry out stable transfer-molding, thereby it is possible to provide a highly reliable semiconductor device.

In order to convert the vertical fastening force of the molding tool into the force for clamping the external connection terminal, the auxiliary member preferably has a trapezoidal cross-sectional shape or the like. With the use of the auxiliary member having such a shape, the external connection terminal cannot only be fitted in the recess of the upper or lower half of the molding tool, but also a gap defined between the auxiliary member and the external connection terminal can be substantially eliminated due to deformation of the auxiliary member, thereby it is possible to prevent formation of resin flashes. It is noted here that if close contact between the auxiliary member and the external connection terminal can be obtained, it is sufficient for preventing formation of resin flashes on the external connection terminal, and it is not always required to convert the vertical fastening force of the molding tool into the force for clamping the external connection terminal by means of the auxiliary member.

As to the auxiliary member, a soft flexible member made of polytetrafluoroehtylene resin, silicone resin or polyamide resin is preferably used. With the use of these materials, since the resin expands due to heating during molding, the degree of close contact between the auxiliary member and the connection terminal is increased, thereby it is possible to prevent formation of resin flashes. Further, with the use of these materials, the mold release and the removal of the auxiliary member from the connection terminal can be facilitated after molding.

Further, according to another configuration of the present invention, a electric circuit board on which an external connection terminal is arranged in a substantially vertical posture, a recess part formed in a cavity so as to position the external connection terminal, and the external connection terminal is clamped by a movable part corresponding to the recess part formed in the cavity while resin is cast in the cavity for transfer-molding.

In this case, an elastic member having an elastic modulus of higher than 1 Mpa but lower than 10 Gpa is preferably set in a contact part between the external connection terminal and the recess part in the cavity.

With this arrangement, it is possible to carry out stable transfer molding with less leakage of resin and with no damage to the external connection terminal vertically arranged.

Meanwhile, in order to carry out transfer-molding with the use of a molding tool, it is raised a problem of how to positionally align the molding tool and components of a power module with one another. Should the accuracy for the positional alignment be unable to be ensured, the external connection terminal cannot be stably fitted in a recess in the upper or lower half of the molding tool during operation of the molding tool (when the components of the module are clamped between the upper and lower halves of the molding tool), resulting in distortion of the external connection terminal, and resin leakage between the upper and lower halves.

According to the present invention, an external connection terminal electrically connected to a predetermined electric circuit formed on a electric circuit board is set on the electric circuit board in a substantially vertical posture, the electric circuit board is set on a guide plate for transfer-molding, the guide plate is then fitted in a recess formed in a predetermined part of an upper or lower half of a molding tool, and finally, resin is cast in the molding tool for transfer-molding.

With this arrangement, there is provided a transfer-molded semiconductor device in which an external connection terminal electrically connected to an electric circuit formed on a electric circuit board, is arranged on the electric circuit board in a substantially vertical posture, and the electric circuit board is mounted on a guide plate.

This guide plate may be a heat spreader as a component of the power module, or may be a member additionally provided as a guide member. With the use of the guide plate, the setting of mounting positions of components at respective manufacturing steps can be facilitated, the continuity and automation through the manufacturing steps can be made, thereby it is possible to enhance the production efficiency. Further, it is possible to facilitate the positioning in the cabity of the molding tool.

In particular, by previously fitting the external connection terminal and the guide plate in the recess of the lower half, it is possible to eliminate the necessity of counting the positioning accuracy for the electric circuit board mounted thereon with components of the power module, in a planar direction in the case of clamping the components between the upper and lower halves, thereby it is possible to expect stable molding.

In this case, it is preferable to carry out transfer-molding so as to expose the backside surfacce of the guide plate. That is, the above-mentioned electric circuit board or the guide plate is arranged to be fitted in the upper or lower half so as to expose the backside surfacce thereof.

By exposing the backside surfacce in such a way, the electric circuit board or the guide plate in the molded product can be provided with heat radiation fins. The guide plate is preferably made of a material having a high thermal conductivity.

Meanwhile, in order to arrange a plurality of external connection terminals, it is preferable to arrange the external connection terminals in an interconnecting condition. That is, the external connection terminals are arranged, being interconnected together, on the electric circuit board, and the connection parts between the terminals are trimmed after transfer-molding. In this case, the external connection terminals may be trimmed by a predetermined length by which the connected parts between the external connection terminals are included.

Should a plurality of external connection terminals be arranged, independent from one another, the external connection terminals should be individually fitted in recesses in the above-mentioned upper or lower half. As a result, it would be difficult to absorb dimensional errors and positional deviation.

On the contrary, if the external connection terminals are connected together, it is possible to eliminate the ncessiting of fitting the external connection terminals into recesses, respectively, and they can be fitted at one side into a single recess formed in the upper or lower half of the molding tool, thereby it is possible to absorb the above-mentioned positional errors and positional deviation.

Explanation has been made hereinabove of the manufacture of a semiconductor device having external connection terminals of a fast-on type for pin-insertion connection. Next, explanation will be made of a manufacture of a semiconductor device having external connection terminals of a receptor for screw fastening connection. It is noted here that both fast-on type for pin-insertion connection, and receptor for screw fastening connection, of external connection terminals are arranged in a direction perpendicular to the electric circuit board, almost the entire part thereof being arranged in the molded resin, and accordingly, they have basic arrangements which are substantially identical with each other.

That is, in order to achieve a second object of the present invention, an external connection terminal electrically connected to a predetermined electric circuit formed on a electric circuit board is arranged on the electric circuit board in a substantially vertical posture, and is bent with a part which will not be molded with resin, so as to set the part horizontally with respect to the electric circuit board, then, the electric circuit board is fitted in a predetermined part of an upper or lower half of a molding tool so as to be positioned, and finally resin is cast in the molding tool for transfer-molding. It is noted that a guide plate may be used for positioning the electric circuit board. Further, the upper or lower halve may be formed therein with a recess to be fitted therein with the above-mentioned bent part.

In the case of the power module of this receptor, there is raised a problem of how to provide a thread mechanism therefor.

According to the present invention, transfer-molding is carried out in such a condition that a thread mechanism serving as a joint part of the external connection terminal, and a container for defining a space necessary for fitting the thread mechanism with another thread mechanism are joined to the bent part of the external connection terminal. It is noted that the transfer-molding may be made in such a condition that the thread mechanism is fastened thereto with another thread part (dummy).

The structure of such a receptor may be molded by using the above-mentioned fast-on type. That is, after a power module of a fast-on type is transfer-molded, an exposed part of the external connection terminal, which has not yet been molded with resin, is bend so as to be substantially horizontal with the electric circuit board.

In this case, the transfer-molding may be carried out with the use of a molding tool in which a protrusion is formed in the upper or lower half of the molding tool so as to accommodate the bent part of the external connection terminal in the resin-molding part, and a second protrusion is formed on the first protrusion at a predetermined position so as to accommodate the thread mechanism serving as the joint part of the external connection terminal while a third protrusion is formed on the second protrusion at a predetermined position so as to define a space necessary for fitting the thread mechanism with another thread mechanism together.

### BRIEF DESCRIPTION OF THE DRAWINGS

Fig. 1 is a sectional view illustrating a structure of a power semiconductor module;
Fig. 2 is a top plan view illustrating the structure shown in Fig. 1;
Fig. 3 is a view for explaining a process of mounting various components on a board formed therein with positioning holes;
Fig. 4 is a view for explaining a process of resin-molding;
Fig. 5 is a view for explaining a process of forming a complete product from a molded product;
Fig. 6 is an enlarged sectional view illustrating a cavity in a molding tool for resin-molding;
Fig. 7a is an enlarged partly-broken perspective view illustrating a part around power supply terminals;
Fig. 7b is a sectional view illustrating the part shown in Fig. 7a;
Fig. 8a is an enlarged partly-broken perspective view illustrating a part around the power supply terminals;
Figs. 8b and 8c are sectional views illustrating the part shown in Fig. 8a as viewed in different directions;
Fig. 9 is an enlarged partly-broken perspective view illustrating a part around the power supply terminals;
Fig. 10a is an enlarged partly-broken perspective view illustrating a part around the power supply terminals:
Fig. 10b is a sectional view illustrating the part shown in Fig. 10a;
Fig. 11 is a perspective view illustrating a structure of the main power terminals;
Fig. 12a is an enlarged partly-broken perspective view illustrating a part around the power supply terminals;
Fig. 12b is a sectional view illustrating the part shown in Fig. 12a;
Fig. 13 is a view for explaining a process of mounting various components onto a board formed therein with positioning holes;
Fig. 14 is a view for explaining a process of resin-molding;
Fig. 15 is a view for explaining a process for completing a complete product from a molded product;
Fig. 16a is a sectional view illustrating a cavity of a molding tool for resin-molding;
Fig. 16b is an enlarged sectional view illustrating a part of the cavity shown in Fig. 16a;
Fig. 17 is an enlarged partly-broken perspective view illustrating a part around the power supply terminals in the molded product;
Fig. 18 is an enlarged partly-broken perspective view illustrating a part around the power supply terminals for explaining a manner of bending the power supply terminals;
Fig. 19a is a sectional view illustrating a mold cavity part for resin-molding;
Fig. 19b is an enlarged sectional view illustrating the mold cavity shown in Fig. 19a;
Fig. 20 is an enlarged partly-broken perspective view illustrating power supply terminal part of a molded product;
Fig. 21 is an enlarged partly-broken perspective view illustrating a part around the power supply terminals for explaining a manner of bending the power supply terminals;
Fig. 22a and 22b are perspective views illustrating a thread part;
Fig. 22c is a sectional view illustrating the thread part shown in Fig. 22a;
Fig. 23 is a sectional view illustrating a part of an upper half of a molding tool, in which external connection terminals are inserted;
Fig. 24 is an enlarged partly-broken perspective view illustrating a part around a power supply terminal part in a molded product;
Fig. 25 is a sectional view illustrating a part of an upper half of a molding tool, in which power supply terminals are inserted;
Fig. 26 is an enlarged partly-broken perspective view illustrating a power supply terminal part of a molded product;
Fig. 27 is a sectional view illustrating a mold cavity part for resin-molding;
Fig. 28 is an enlarged partly-broken perspective view illustrating a power supply terminal part of a molded product;
Fig. 29 is a sectional view illustrating a mold cavity part for resin-molding:
Fig. 30 is an enlarged partly-broken perspective view illustrating a power supply terminal part of a molded product;
Fig. 31 is an enlarged sectional view illustrating the power supply part shown in Fig. 30;
Fig. 32 is an enlarged sectional view illustrating the power supply part shown in Fig. 30;
Fig. 33 is a view for explaining a process of mounting various components onto a heat spreader in a conventional power semiconductor module:
Fig. 34 is a view for explaining a process of fitting a protecting casing onto the heat spreader;
Fig. 35 is a view for explaining a process of casting silicone resin into the protecting case;
Fig. 36 is a view for explaining a process of casting epoxy resin into the protecting case;
Fig. 37 is an enlarged sectional view illustrating a mold cavity part for resin-molding;
Fig. 38 is an enlarged sectional view illustrating the mold cavity part for resin-molding;
Fig. 39 is a schematic sectional view illustrating a molding tool having sliding parts in the cavity thereof;
Fig. 40 is a schematic view illustrating a molding tool having sliding parts in a cavity;
Fig. 41 is a view for explaining a process of moving the sliding part in the cavity by guide pins;
Fig. 42 is a view for explaining a process of moving the sliding part in the cavity by guide pins;
Fig. 43 is a view for explaining a process of moving the sliding part in the cavity by guide pins;
Fig. 44 is a view for explaining a process of moving the sliding parts in the cavity by guide pins;
Fig. 45 is a view for explaining a process of moving the sliding parts in the cavity by inclined parts formed in the molding tool;
Fig. 46 is a view for explaining a process of moving the sliding parts in the cavity by inclined parts formed in the molding tool;
Fig. 47 is a view for explaining a process of moving sliding parts in the cavity by inclined parts formed in the molding tool;
Fig. 48 is a view for explaining a process of moving sliding parts in the cavity by the inclined parts formed in the molding tool;
Fig. 49 is a view for explaining a process of moving movable parts in the cavity by the inclined parts formed in the molding tool;
Fig. 50 is a view for explaining a process of moving sliding parts in the cavity by the inclined parts formed in the molding tool;
Fig. 51 is a view for explaining a process of moving sliding parts in the cavity by the inclined parts formed in the molding tool;
Fig. 52 is a view for explaining a process of moving sliding parts in the cavity by the inclined part formed in the molding tool;
Fig. 53 is a top view illustrating a molding tool in which recesses are formed in sliding parts provided in the molding tool;
Fig. 54 is a schematic view illustrating a semiconductor device in which a vertical external connection terminal part clamped by the sliding parts in the cavity is applied thereover with an insulating film;
Fig. 55 is a schematic view illustrating a semiconductor device in which vertical external connection terminals clamped by the sliding parts in the cavity is applied thereover with an insulating film;
Fig. 56 is a top view illustrating a molding tool in which elastomers are provided in the sliding parts in the cavity;
Fig. 57 is a top view illustrating an inclined angle of the guide pin;
Fig. 58 is a view showing an inclined angle of the inclined part formed in the upper half of the molding tool; and
Fig. 59 is a view showing an inclined angle of the inclined part formed in the sliding part.

### DESCRIPTION OF PREFERRED EMBODIMENS

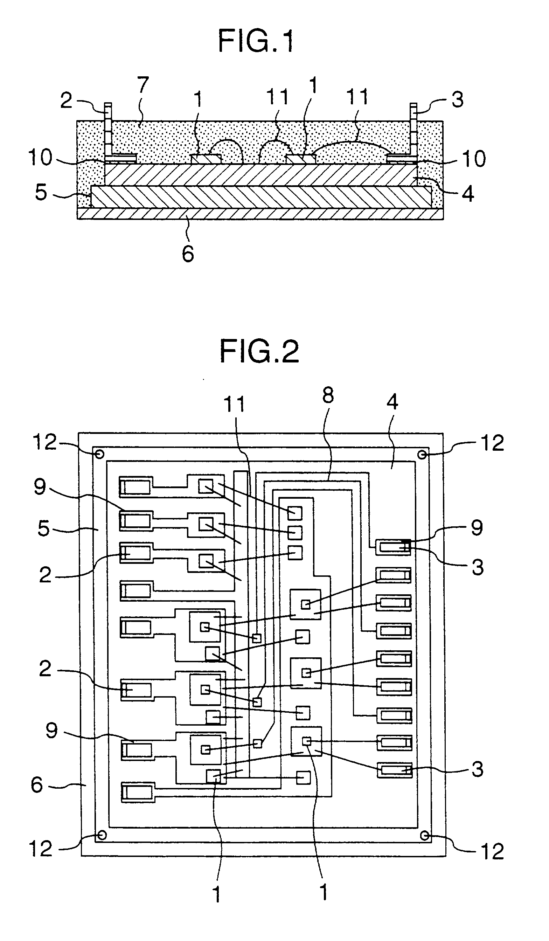

Explanation will be hereinbelow made of embodiments of the present invention with reference to Figs. 1 to 56.

First, a method of manufacturing a power semiconductor module in which external connection terminals (power supply terminals and control signal terminals) of a fast-on type for pin insertion connection will be explained with reference to Figs. 1 to 12.

Fig. 1 is a sectional view which schematically shows a structure of a power semiconductor module comprising components 1 including a power semiconductor element, power supply terminals 2, control signal terminals 3, an insulating circuit board 4, a heat spreader 4 and a board 6 with positioning holes, on which the aforementioned parts are mounted, and these parts are covered with resin 7 so as to obtain the power semiconductor module.

As mentioned above, if the power supply terminals 2 and the control signal terminals 3 are arranged, perpendicular to the insulating circuit board 4, a distance between an unmolded part of the power supply terminals 2 and the control signal terminals 3 which serve as external connection terminals, and the heat spreader 5 (insulating circuit board 4) can be ensured, and accordingly, discharge phenomenon can hardly occur therebetween, and accordingly, damage to the module thereby, can hardly occurs.

Fig. 2 is a plan view illustrating the power semiconductor module as viewed from the top. The components 1 including the power semiconductor elements are joined by soldering or the like at predetermined positions to an electric circuit 8 laid on the insulating circuit board 4. Further, the power supply terminals 2 and the control signal terminals 3 are joined to pad parts 90 on the circuit board 8 by solder 10. The components 1 including the power semiconductor element, the electric circuit 8, the power supply terminals 2 and the control signal terminals 3 are connected together through the intermediary of metal wires so as to complete the connection to the electric circuit 8. The insulating circuit board 4 is mounted on the board 6 with positioning holes, which is then joined to the former by soldering. Further, the heat spreader 5 is formed therein with attaching holes 12 through which parts such as heat radiation fins are attached to the heat spreader 5. It goes without saying that the attaching holes 12 also pierce through the board 6 with positioning holes. Further, the mounting surface of the insulating circuit board 4 is covered with the resin 7, except a part of the power supply terminals and a part of the control signal terminals 3 and the backside surfacce of the board 6 with positioning holes. In this arrangement, aluminum wires or the like may be used as the metal wires. The heat spreader 5 may be made of copper alloy, aluminum alloy or the like. Further, the board with positioning holes is made of a metal material such as copper alloy or iron-nickel alloy.

The heat spreader and the board with attaching holes are made of materials having substantially equal heat expansion coefficients in combination or the former is made a metal material having a coefficient and the latter made of a metal material having a coefficient lower than that of the former. With these combination, the module may be restrained from warping.

Further, the positioning holes may be formed in the heat spreader 5, instead of using the board 6 with positioning holes.

Incidentally, it is not always required that both power suppy terminals 2 and control signal terminals 3 are vertically joined, but it may possible to allow either the power supply terminals 2 or the control signal terminals 3 to be vertically joined.

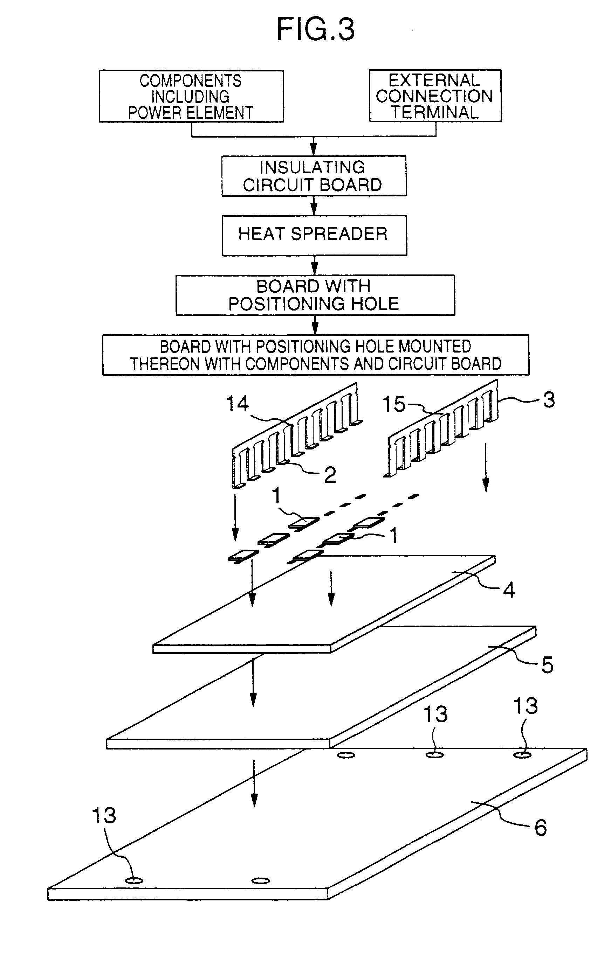

Referring to Figs. 3 to 5, explanation will be made of process of manufacturing the above-mentioned power semiconductor module structure.

Fig. 3 shows a manufacturing process of mounting various components on the board 6 with positioning holes, which will be hearinbelow simply denoted as "guide plate". Explanation will be outlined of mounting various components onto the guide plate 6.

First, the heat spreader 5 is joined to the guide panel 6 at a predetermined position thereof. At this time, the predetermined position is set by using reference holes 13 on the guide plate 6 as cardinal points. Further, the subsequent manufacturing steps are carried out by also using the reference holes 13 as the cardinal points, and accordingly, these steps can be continuously and automatically carried out. Next, the insulating circuit board 4 is joined to the heat spreader 5 by soldering or the like. Further, components including a power semiconductor element are joined to an electric circuit which is not shown, at predetermined positions on the insulating circuit board 4, by soldering or the like. Thereafter, the power suppy terminals 2 and the control signal terminals 3 are joined to pad parts which are not shown, on the electric circuit by soldering or the like.

It is noted that the power supply terminals 2 and the control signal terminals 3, which are respectively plural in number, are mechanically coupled together by means of coupling parts 14, 15. Accordingly, the power supply terminals 2 and the control signal terminals 4 are vertically joined onto the insulating circuit board 4, stably.

It is noted that the order of joining the components 1 including the power semiconductor element, the power supply terminals 2 and the control signal terminals 3, the insulating circuit board 4, the heat spreader 5 and the guide plate 6 should not be limited to that explained in this embodiment, but any other order can be taken within the process in which the power suppy terminals 2 and the control signal terminals 3 are vertically joined to the insulating circuit board 4.

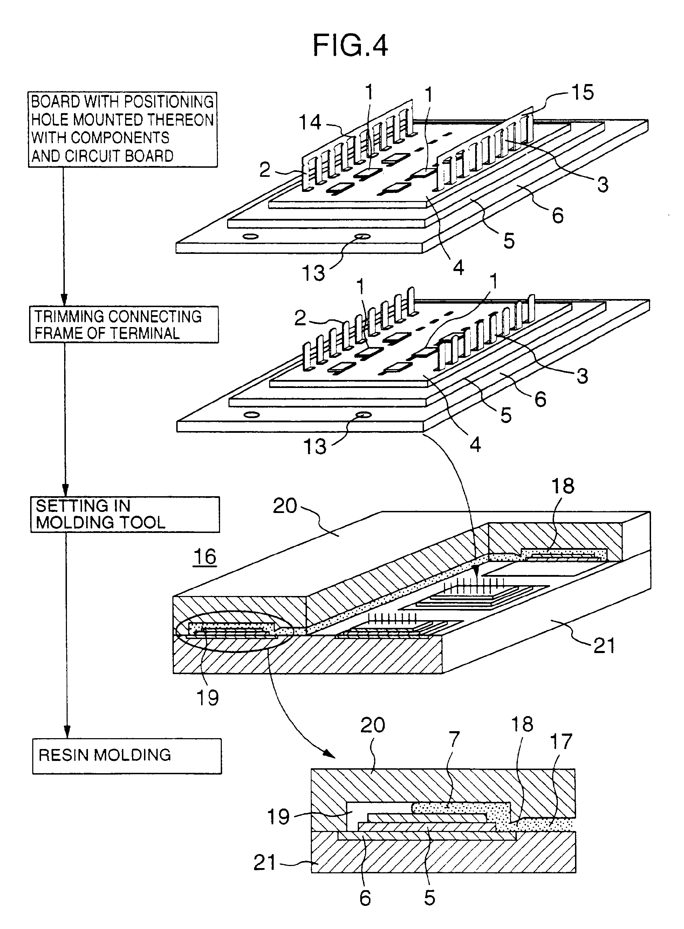

Fig. 4 shows a process of resin-molding a product with the use of a molding tool.

After the components are mounted of the guide plate 6, the coupling parts 14 connecting the power supply terminals 2 together, and the coupling parts 15 connecting the control signal terminals 3 together are trimmed off so as to separate the terminals from one another. In this case, the coupling parts 14, 15 are trimmed off in such a way that the power supply terminals 2 and the control signal terminals 3 can ensure predetermined lengths.

Further, the terminals, the circuit board and the components 1 are connected by metal wires so as to complete the electric circuit which is then set in the cavity of the molding tool 16.

In this embodiment, explanation will be made of such a case that epoxy resin as thermosetting resin is used to carry out transfer-molding. It goes without saying that the molding tool has been heated up to a temperature at which epoxy resin is hardened. The resin molding is carried out in such a way that molded resin tablets which are not shown are cast into pots which are not shown, within the molding tool, and then a plunger which is not shown is pressed. The resin pressed by the plunger is heated and molten, and accordingly, flows from a runner in the molding tool into the cavity 19 through a gate 18. Then it is hardened through hardening action so as to be formed into a molded product.

Explanation will be made of a condition in the cavity. That is, the guide plate 6 is clamped between the upper half 20 and the lower haft 21 of the molding tool 16, and the other parts including the heat spreader 5 are set in the cavity 19. In the configuration of this embodiment, the guide plate 6 is substantially fitted in the lower half 21 of the molding tool so that the positioning in the cavity 19 is made by using the reference holes 13 in the guide plate 6 and positioning pins which are not shown, within the molding tool. By this positioning, the power supply terminals and the control signal terminals can be fitted in a recess formed in the upper half of the molding tool.

Thus, in a condition in which all parts are set in the cavity 19, resin 7 is cast into thereinto so as to cover all parts, except of parts of the power supply terminals and the control signal terminals, and the backside surfacce of the guide plate 6, and accordingly, the molded product is completed.

Since the backside surfacce of the guide plate 6 is not molded, heat generated from the power semiconductor device or the like can be radiated from the backside surfacce of the guide plate 6.

Although the explanation has been made in this embodiment, of such a case that the terminal insertion part is present in the upper half 20 of the molding tool, the terminal insertion part may be provided in the lower half 21 of the molding tool with no hindrance. Further, the molding resin should not be limited to the thermosetting resin, but thermoplastic resin can also be used therefor. This fact can be similarly effected in any of various embodiments which will be detailed hereinbelow.

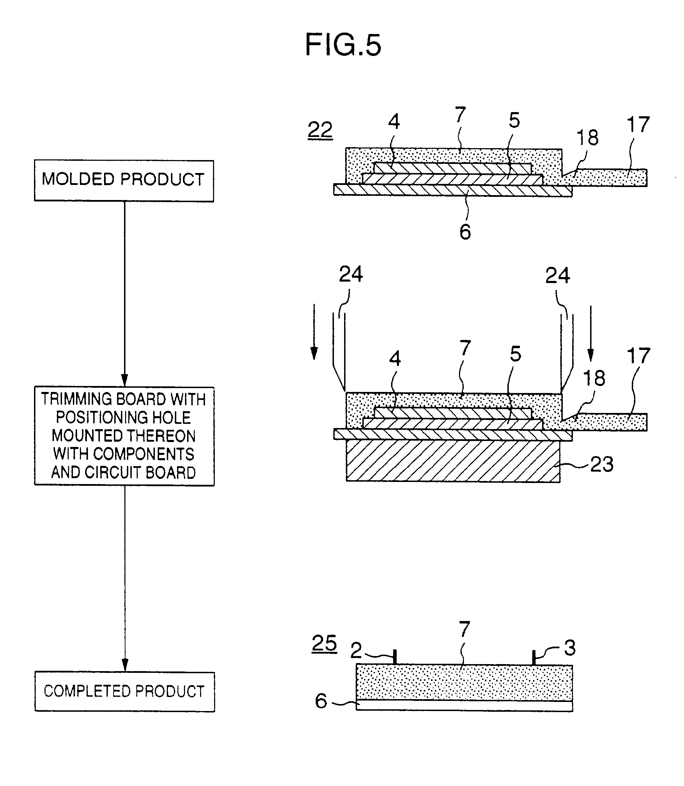

Fig. 5 is a process of obtaining a complete product from the molded product shown in Fig. 4.

The resin-molded product 22 is fixed to a molded product setting bed 23, and the runner 17, the gate 18 and a part of the guide plate 6 which has not been used further after resin-molding are trimmed off by a cutting blade 24 so as to obtain the completed product 25.

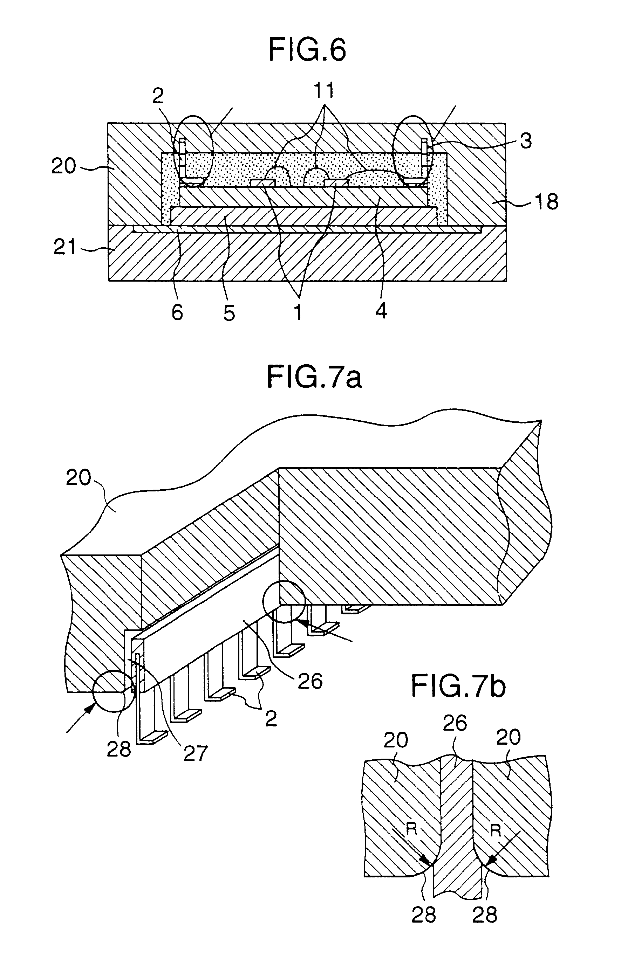

Referring to Fig. 6 which is a sectional view illustrating the cavity part of the molding tool for resin-molding the power suppy terminals 2 and the control signal terminals 3 which are vertically arranged.

Parts to be exposed of the power suppy terminals 2 and the control signal terminals 3 are inserted in the terminal insertion part of the upper half 20 of the molding tool, and are then molded with resin. The insertion parts A, B thereof can be made by processes which are similar to each other, and accordingly, a process for the power supply terminals 2 will be typically explained in detail.

Referring to Fig. 7a which is an enlarged partly-broken perspective view, a heat-resistance adhesive tape 26 is applied on the outer surface of the terminals in a part which will be exposed from the resin-molded surface, and the terminals are set in the upper half 20 of the molding tool. The step of applying the heat-resistance adhesive tape 26 is carried out after trimming of the terminal coupling parts as shown in Fig. 4.

Fig. 7b is an enlarged view illustrating the part A. In order to insert the terminals 2 into a terminal accommodation part 27 of the upper half 20 of the molding tool, an end surface 28 of the terminal accommodation part 27 is chamfered so as to be rounded to a radius of curvature of 0.5 to 0.2 mm. With this arrangement, the adhesive tape 26 applied to the terminals can be easily inserted upon fastening of the molding tool. Further, through the deformation of the adhesive tape 26, positional deviation of the setting positions of the terminals in the molding tool can be absorbed. Further, the thickness of the terminal accommodation part 17 is set to be narrower than that that of the terminals by 0.1 to 0.2 mm, and accordingly, the adhesive tape is compressed and deformed upon insertion of the terminals, and accordingly, it is possible to enhance the adherence to the surfaces of the terminals. The heat-resistance adhesive tape may be made of polyimide resin, polytetrafluoroethylene resin, silicone resin or the like.

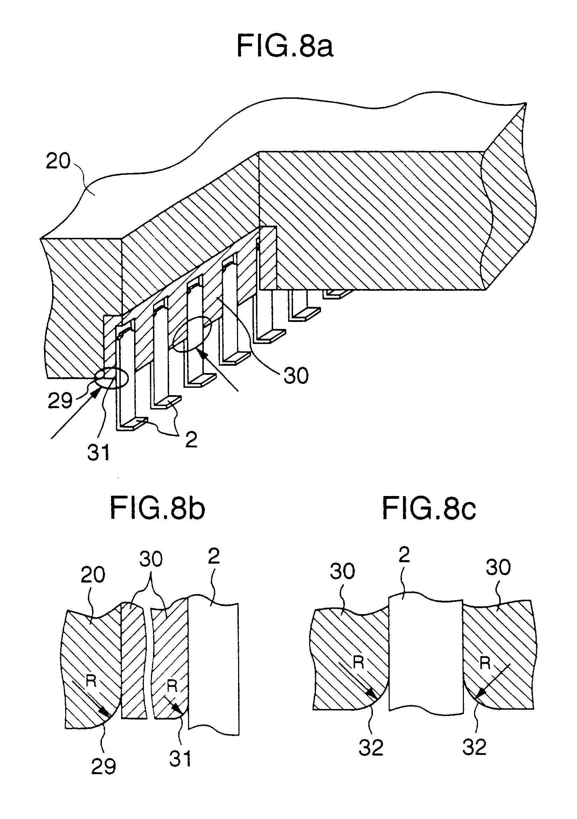

Another configurations of the molding tool is shown in Figs. 8a to 8b. Fig. 8a is an enlarged partly-broken perspective view illustrating a part around the power supply terminal. In this arrangement, an elastomer article 30 in a cap-like shape is fitted on the end surface parts of the terminals which will be exposed from the resin molded surface, and is then set in the upper half 20 of the molding tool. The step of attaching the elastomer article 30 is carried out after trimming off of the terminal couplings shown in Fig. 4. The elastomer article 30 is formed therein with a groove adapted to be fitted therein with the power supply terminals 2 or the control signal terminals 3 to be attached. The size of the groove of the elastomer article 30 is such that the mold resin can be prevented from entering the groove during molding after the elastomer article is attached to the power suppy terminals 2 and is then fitted in the groove. Accordingly, since the elastomer article can be deformed and compressed during fastening of the molding tool, the adherence to the surfaces of the terminals can be enhanced. The elastomer material may be made of polytetraflouroethylene resin, silicone resin or the like.

Fig. 8b shows an enlarged view illustrating the part A shown in Fig. 8a. An insertion part 29 of the upper half 20 is chamfered to so as to be rounded having a radius of about 0.5 to 2.0 mm in order to facilitate the insertion of the elastomer article 30 thereinto. The terminal insertion part of the elastomer article 30 has a chamfered structure of a radius of curvature of about 0.2 to 1.0 mm with which the terminals can be easily inserted thereinto. The chamfered structure of the elastomer article 30 having a radius of cuirvature of 0.2 to 1.0 mm can prevent the mold resin from entering into the groove.

Fig. 8c is an enlarged view illustrating a part B shown in Fig. 8a. The end surfaces 32 of the terminal accommodation part are chamfered to a curvature having a radius of about 0.2 to 1.0 mm, similar to Fig. 8b. With this arrangement, it goes without saying that the distal end parts of the terminal is also chamfered in order to facilitate the insertion thereof.

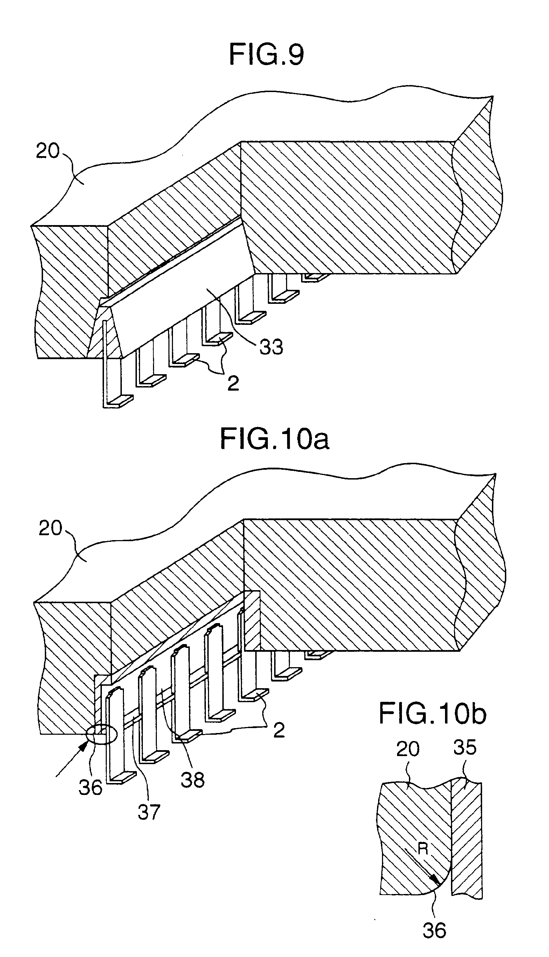

Fig. 9 shows another configuration of the molding tool. Fig. 9 is an enlarged partly-broken perspective view illustrating a part around the power supply terminals. A trapezoidal elastomer article is fitted onto the parts of the terminals which are exposed from the resin-molded surface, and is set in the upper half of the molding tool. During the insertion into the upper half, the trapezoidal elastomer article 33 is deformed so as to be made into close contact with the outer surfaces of the terminals 2 so as to offer such an advantage that the adherence to the surfaces of the terminals can be enhanced. Further, since the elastomer article is trapezoidal, positional deviation of the terminals can be absorbed. This trapezoidal elastomer article 33 may be made of polytetrafluoroethylene resin, silicone resin or the like.

Another configuration of the molding tool is shown in Fig. 10a which is an enlarge partly-broken perspective view illustrating a part around the power supply terminals. This configuration is such that a container 36 cast therein with a liquid medium 38 is fitted on the terminals exposed from the resin-molded surface, and is set in the upper half 20.

Fig. 10b is an enlarged view illustrating a part A shown in Fig. 10a. The accommodation part 36 of the upper half 20 is chamfered by a radius of curvature of 0.5 to 2.0 mm in order to facilitate the insertion of the container 35 cast with the liquid medium, and this container 35 is formed therein with insertion holes 37 having a size which is slightly larger than that of the terminals 2. The liquid medium 38 that cannot be evaporated even though it is heated up to a temperature of 180 to 200 deg. and that is cast in the container 35 has a viscosity which can prevent the medium from flowing out from the insertion holes 37. The liquid medium is a material which can facilitate the clean-off thereof, that is, for example, silicone oil or mineral oil. The container cast therein with the liquid medium may be made of polytetrafluoroethylene resin, silicone resin or the like, which can be easily parted from the molding tool after molding. With this arrangement, the are may be offered such an arrangement that simply washing after molding allows the terminal surfaces to be cleaned.

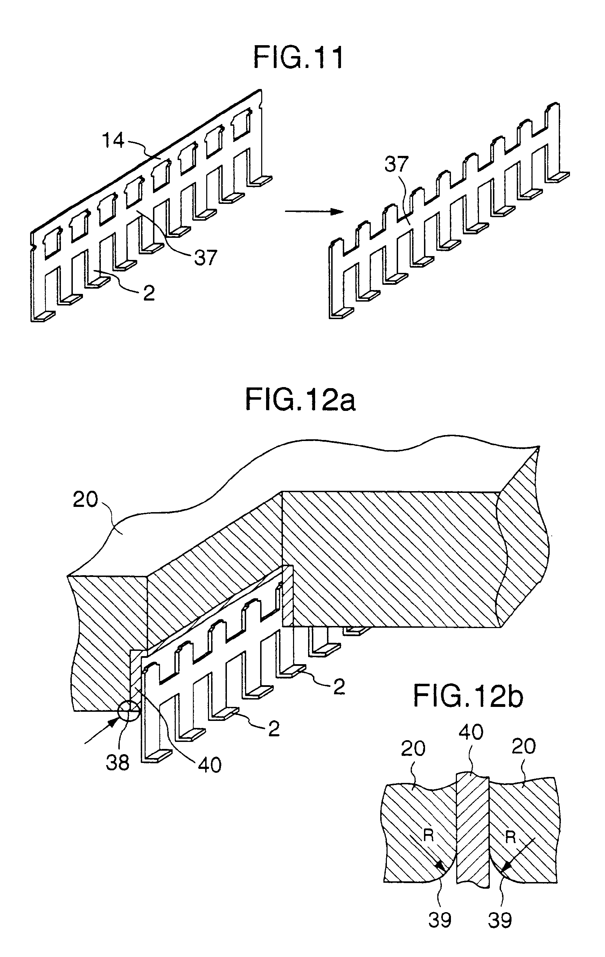

Fig. 11 shows another configuration of the structure in which a plurality of the power supply terminals or the control signal terminals are connected together. The structure of the power supply terminals will be hereinbelow explained typically in this configuration. The terminal structure has dam bars 37 between the power supply terminals 2 together with the terminal coupling frame 14 during formation of the power supply terminals 2. With this arrangement, the sectional shapes of the terminals 2 and the dam bars 37 can be regarded to form a single planar member, and accordingly, the stiffness can be increased, thereby it is possible to prevent the terminals from be deformed when the terminal coupling part 14 is removed. Further, the provision of the dam bars 37 can offer such an advantage that the resin can be prevented from flowing out between the terminals.

Fig. 12a is an enlarged partly-broken perspective view illustrating a part around the power supply terminals when using the terminal structure shown in Fig. 11. In this arrangement, the elastomer article 40 is fitted on the terminals exposed from the resin molded surface, so as to be extend up to the dam part, and is then set in the upper half 20.

Fig. 12b is an enlarged view illustrating a part A shown in Fig. 12a. The accommodation part 38 of the upper half 20 is chamfered so as to have a radius of curvature of about 0.5 to 2.0 mm in order to facilitate the insertion of the elastomer article. Accordingly, the elastomer article can be compressed, and deformed during the fastening of the molding tool so as to enhance the adherence thereof to the surfaces of the terminals. Further, with the provision of the dam bars, the space between the terminals can have a uniform thickness, thereby it is possible to allow the elastomer article to be uniformly compressed. The elastomer article may be made of polytetrafluoroethylen resin, silocone resin or the like.

Either of the embodiments which have been explained hereinabove exhibits such an advantage that occurrence of resin flashes during molding can be prevented. Further, it can exhibit such an advantage that since the heat-resistant tape or the elastomer article is deformed during fastening of the molding tool, deviation of the set position of the terminals can be absorbed. Moreover, since the components are integrally incorporated with one another by resin-molding, there is provided such an advantage as to enhance the reliability of moisture-resistance.

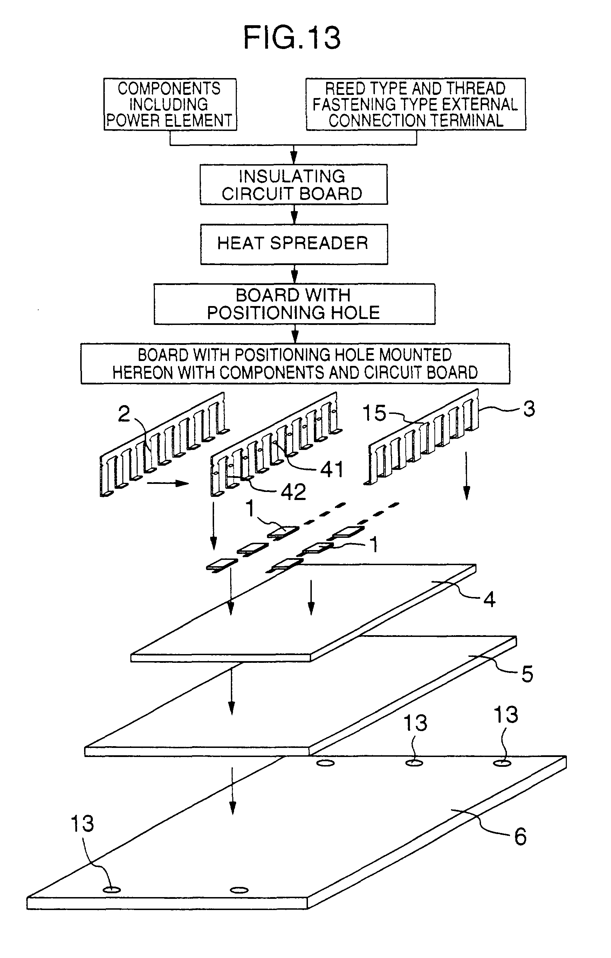

Next, explanation will be made of a manufacture of a power semiconductor module having external connection terminals of a receptor for screw fastening connection with reference to Figs. 13 to 32.

It is noted here that either the fast-on type for pin insertion connection or the receptor for screw fastening connection has such an arrangement that almost parts located in the molding of the external connection terminals are arranged, perpendicular to the electric circuit board, and accordingly, both are basically identical with each other.

Referring to Figs. 13 to 15, a process of manufacturing a semiconductor module structure of a receptor for scre fastening connection will be explained. In this process, the power supply terminals or the control signal terminals are processed in the manufacture in a way substantially the same as those of the fast-on type, and thereafter, the power supply terminals and the control signal terminals are bent.

Referring to Fig. 13, which a process of mounting various components on a guide plate 6 formed therein with positioning holes.

As shown in the figure, the manufacturing process is similar to that for the fastening type for pin sinsertion connection, with large exception of the provision of through-holes 41 for connecting the power supply terminals 2 as a main component, with an external unit through fastening of screws.

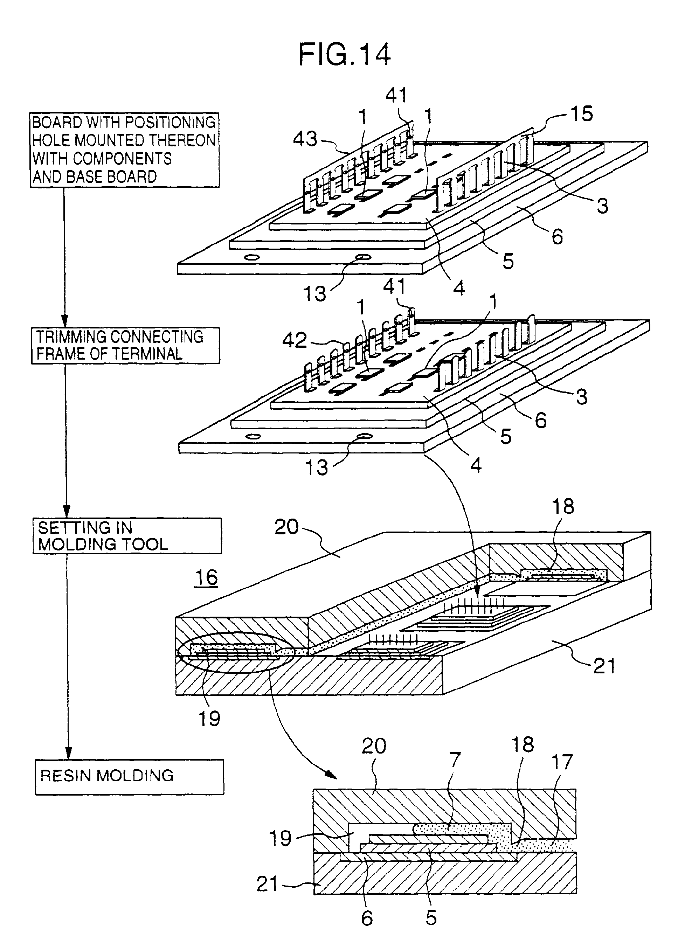

Referring to Fig. 14, an explanation will be made of a process of resin-molding the product shown in Fig. 13. This process is also similar to that for the fast-on type for pin insertion type.

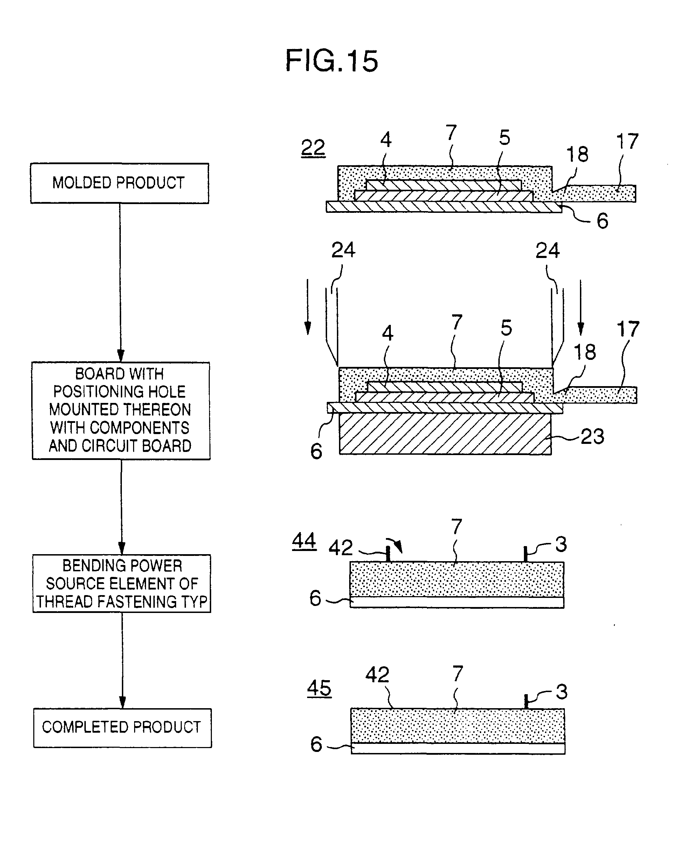

Referring to Fig. 15, the process of resin-molding the product shown in Fig. 14 with the use of the molding tool.

Up to the step of trimming a runner 17 and a gate 18 which have not been required any more, from the resin-molded product 22 with the use of the trimming blade 2, steps similar to those for the fast-on type for pin insertion connection are taken with the exception of steps which will be explained hereinbelow.

That is, the trimmed molded product 44 is made into a complete product 45 by bending the exposed parts of power supply terminals 42 toward the resin-molded surface.

As to the receptor for screw fastening connection, there has been offered such a problem of how to provide a thread mechanism therefor.

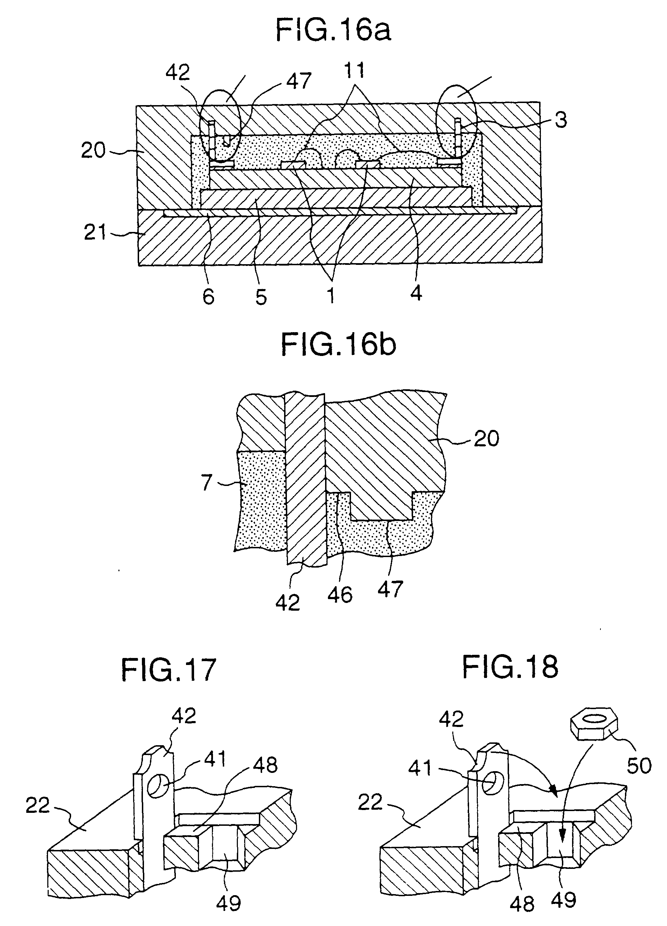

Explanation will be made of the provision of the thread mechanism with reference to Figs. 16a to 32. A part A and a part B of the power supply terminals 42 and control signal terminals 44, which are made into contact with the upper half 20 of the molding tool have structures which are similar to those of the fast-on type for pin insertion connection having been already explained. With this arrangement, the exposed parts of the power supply terminals and the like are bent toward the outer surface of the molded product so as to flush with the molded surface, thereby it is possible to enhance the electric insulation. Further, since the terminal part of the molded product is integrally molded with resin, the mechanical strength of the terminals in the molded product can be enhanced during screw fastening connection. Further, the parts are integrally incorporated with the resin so as to offer such an advantage that the reliability of moisture resistance for the module can be enhanced.

Fig. 16b is an enlarged view illustrating the part A (a part around the power supply terminals 42), which is one of features of this embodiment. That is, the upper half 20 is formed, in the vicinity of the power supply terminal 42, with a protrusion 46 for forming a power supply terminal accommodating part so that the power supply terminal 42 can be flush with the outer surface of the molded product when it is bent, and a with protrusion 47 forming a thread forming part accommodating part for accommodating a thread forming part underneath the power supply terminal. This arrangement can exhibit such that the terminal accommodation part and the thread forming part accommodation part can be formed in batch. The protrusion 47 forming a thread forming part accommodating part is arranged so as to align with the through-hole in the power supply terminal 42 which has been bent. Similarly, the protrusion 46 forming the power supply accommodating part is arranged so as to accommodate the power supply terminal 42 which has been bent.

Fig. 17 is an enlarged view which shows a part around the power supply terminal in a molded product parted from the molding tool shown in Fig. 16a, that is, the power supply terminal 42 is bent inward. Namely, the molded product 22 is provided therein with recesses for the terminal accommodating part 48 and the thread forming part accommodating part 49 which is formed by the protrusions 46, 47 in the upper half 20, in batch.

Fig. 18 is a perspective view a part around the power supply terminal to be bent. That is, after a thread forming part 50 is inserted in the thread forming part accommodating part 49, the exposed part of the power supply terminal 42 is bend into the terminal accommodating part 48 formed in the molded product so as to align the through-hole 41 formed in the power terminal 42 with the thread forming part accommodating part 49 so as to complete the configuration. With this arrangement, the terminal is embedded in part in the molded product so as to exhibit such an advantage as to enhance the electric insulation.

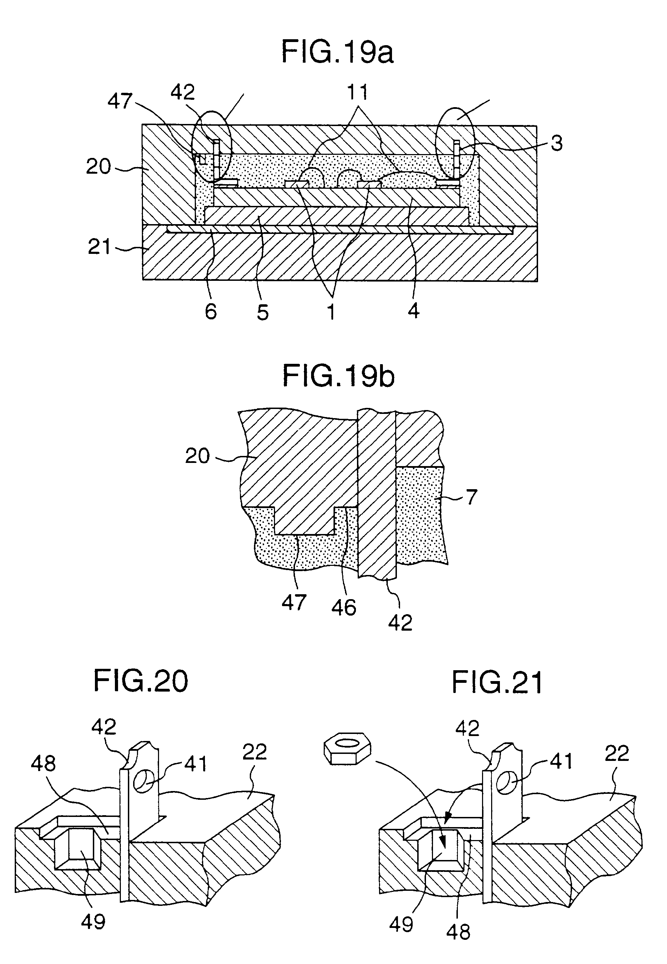

It is noted the power supply terminal 42 in this configuration of the present embodiment may be bent outward as shown in Figs. 19 to 21. A process of and a molding tool for manufacturing this type are the same as those as mentioned above, except that the direction of bending the power supply terminal is different.

By bending the power supply terminals 42 outward, the thread forming part accommodating part may be arranged outside of the surface of the electric circuit, thereby it is possible to facilitate the design of the electric circuit.

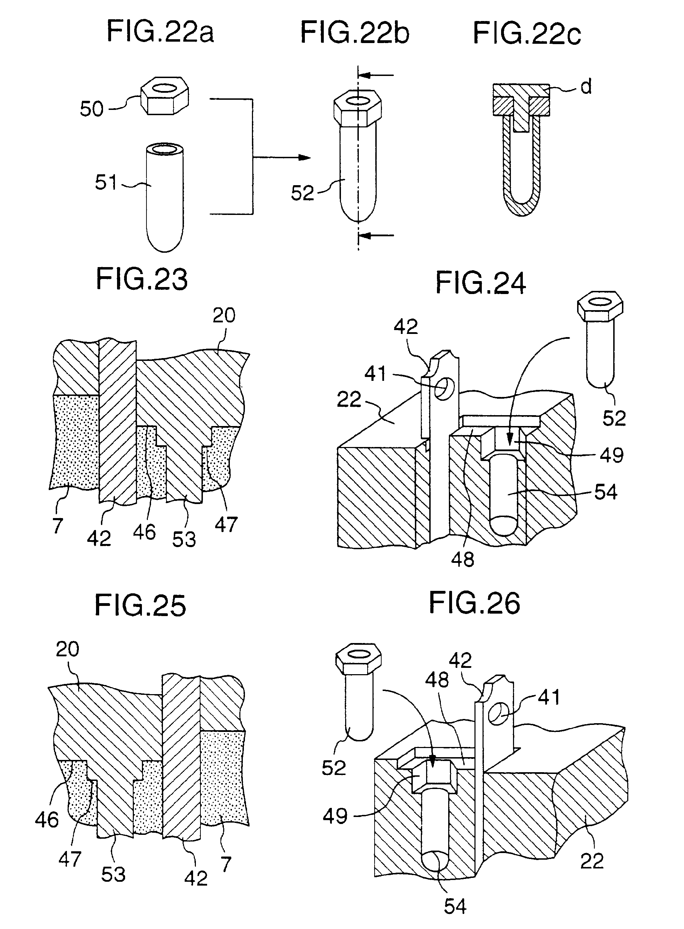

Next, Fig. 22a to Fig. 22b show the structure for forming a thread part 52 including the thread forming part 50. In this structure, the thread forming part 50 is combined with a container for defining a space so as to form the thread part 52. In this arrangement, the container 51 can use a screw which is longer than the thread forming part 50. With the use of the screw d longer than the thread forming part 50, it goes without saying that the reliability of thread fastening can be enhanced.

The thread forming part may be made of any kind of metal materials, and further, the container defining a space may be made of a thermosetting material such as epoxy resin, phenolic resin or the like, or heat-resistant thermoplastic materials such polyphenylenesulfide resin, polybutylene terephthalate resin or the like.

Fig. 23 shows a structure of a molding tool to which the thread part is applied. Fig. 23 is an enlarged view illustrating a part of the upper half 20 around the power supply terminal. The part of the upper half 20 around the power supply terminal 42 has such a structure which comprises a protrusion 46 forming a power supply terminal accommodating part so that the power suppy terminal 42 is flush with the outer surface of the molded product when it is bent, a protrusion 47 forming a thread forming part accommodating part for accommodating the thread forming part underneath the power supply terminal and a protrusion 53 forming a container accommodating part for accommodating a space defining container 52. This arrangement can offer such an advantage that the power supply terminal accommodating part, the thread forming part accommodating part and the container accommodating part can be formed in batch.

Referring to Fig. 24 is a schematic view illustrating the molded product which is parted from the molding tool shown in Fig. 23, and in which the power supply terminal is bent. In this arrangement, the power supply terminal is bend intward. That is, recesses serving as the terminal accommodating part 48, the thread forming part accommodating part 49 and the container accommodating part 52 are formed in the molded product 22 in batch by means of the protrusions 46, 47, 53 in the upper half 20. After the thread part 52 is inserted in the recess, the exposed part of the power supply terminal 42 is bent toward the terminal accommodating part 48 formed in the molded product so as to align the through-hole 41 formed in the power supply terminal 42 with the recess in order to complete the shape.

In the configuration of this embodiment, the power supply terminal may be bent outward as shown in Figs. 25 and 26. The molding tool and the manufacturing process, the same as the above-mentioned molding tool and manufacturing process can be used, except that the bending direction is different.

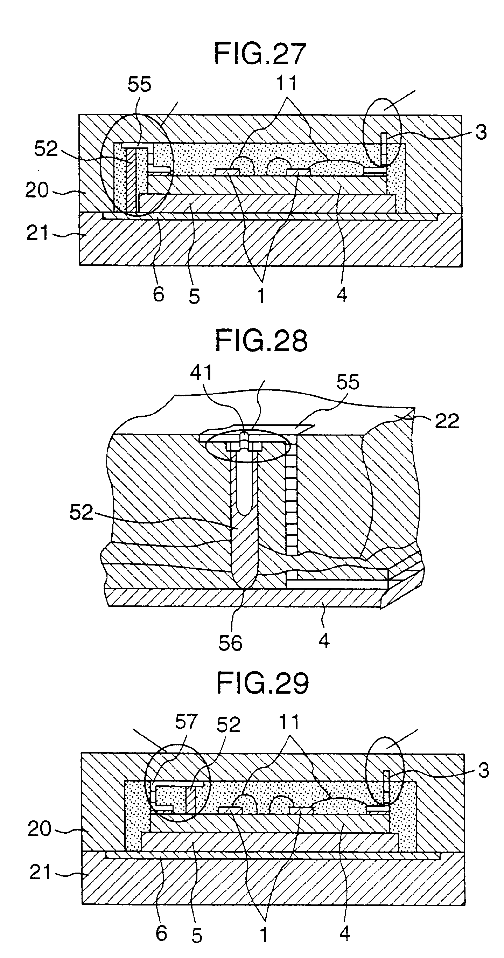

Next, explanation will be made of a process of manufacturing a semiconductor module structure of another receptor with reference to Figs. 27 to 32. In this process, molding is carried out after the power supply terminal and the control signal terminals are bend into desired shapes.

Fig. 27 is a sectional view illustrating a cavity in a molding tool for molding, after the power supply terminals and the control signal terminals are bent into desired shapes. In the configuration of the embodiment, the part B of the control signal terminals which makes into contact with the upper half 20 has a structure similar to that of the fast-on type. This may be molded after it is bent into a desired shape.

In a part A, a power supply terminal 55 which has been bent outward, and is joined to the insulating circuit board 4, is set in the cavity. That is, underneath the through-hole 41 in the power supply terminal 55 bent outward, the thread part 52 shown in Fig. 22 and joined by solder or the like is set in the cavity. In this arrangement, the distal end of the thread part 52 is made into contact with the guide plate 6. Thereafter, the resin molding is carried out.

Further, the upper half 20 may be formed therein with a recess into which the bent part (horizontal part) of the power supply terminal is fitted. With this arrangement, since the outer surface of the thread fastening mechanism of the power supply terminal 55 is not molded, the necessity of an additional step of removing molded resin from the outer surface of the thread fastening mechanism can be eliminated in the case of screw fastening connection with another terminal.

Fig. 28 which an enlarged view of the power supply terminal of the molded article molded by the molding tool shown in Fig. 27.

The exposed surface of the power supply terminal is found on the same surface as that of the outer surface of the molded product 22, and further, the part around the terminal is integrally molded with molded resin. Further, the thread part 52 is also integrally incorporated with the molded resin. The distal end part 56 of the thread part 52 is made into contact with the guide plate 6 formed therein with the positioning holes. This arrangement can offer such an advantage that the bent part of the terminal can be prevented from being deformed by resin-molding. Further, since the thread part accommodating part is arranged outside of the insulating circuit board 4, there is offered such an advantage that the design of the circuit can be facilitated.

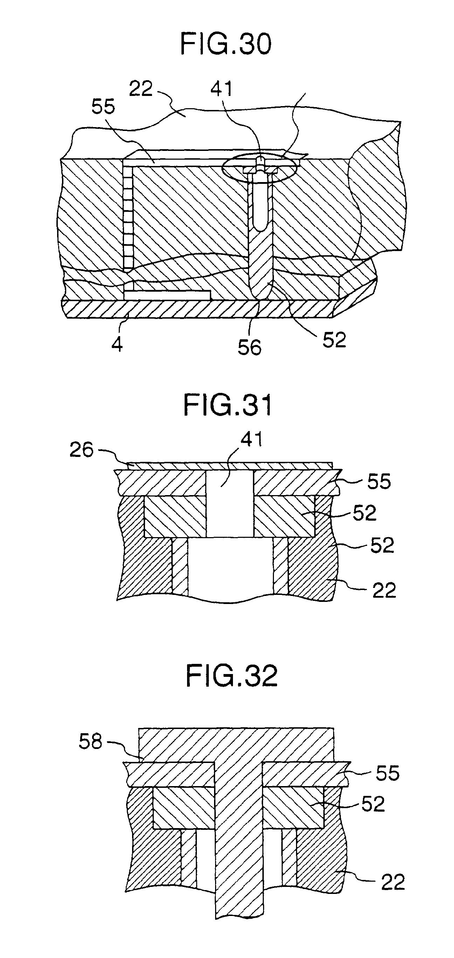

The power supply terminal 42 as shown in Figs. 29 and 30 may be bend inward in the configuration of this embodiment.

In either case, the terminal and thread part can be both integrally incorporated with resin, there is offered such an advantage that the mechanical strength of the thread fastening part can be enhanced. Further, all parts are integrally incorporated with one another by resin, there is offered such an advantage that the reliability of the moisture resistance of the module can be enhanced. Further, the exposed part of the terminal is flush with the outer surface of the molded product, there is offered such an advantage that the electric insulation can be enhanced.

In such a case of molding after the power supply terminal and the control signal terminal are bent into desired shapes, the bent parts of the terminals may be configured as shown in Figs. 31 and 32.

Referring to Fig. 31 which is an enlarged view illustrating a part A shown in Figs. 28 and 30, a heat-resistant adhesive tape 26 is applied over the outer surface of a terminal 55 making contact with an upper half 22.

Referring to Fig. 32 which is an enlarged view illustrating the part A shown in Figs. 28 and 30, a dummy thread 58 similar to that used upon connection with an external terminal is fastened onto the outer surface of the terminal 55 which makes contact with the upper half 22. Since the dummy thread 58 is fastened, there is offered such an advantage that the thread fastening part can be prevented from being deformed by molding pressure. In this case, it is required to form a recess to be fitted with the dummy thread 58 in the upper half 22 of the molding tool.

With the arrangements shown in Figs. 31, 32, there is offered such an advantage that occurrence of resin flashes on the outer surface of the power supply terminal (horizontal part), which are likely to be formed during resin-molding, can be prevented.

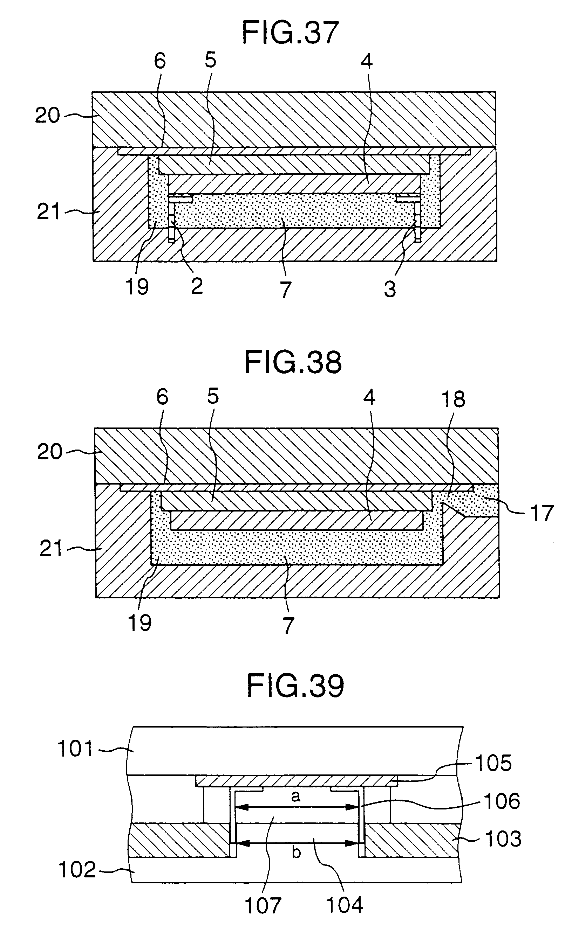

Next, explanation will be made of such an embodiment that the external connection terminals 2, 3 are set in the lower half 21 with reference to Figs. 38 and 39. This embodiment is the same as the above-mentioned embodiments, except that the external connection terminals 2, 3 are set in the lower half 21. In this embodiment, explanation will be made of a molding process for the fast-on type power module. However, it goes without saying that the same process can be taken for the receptor power module.

Fig. 37 is a sectional view illustrating a mold cavity in such a case that the resin-molding is carried out after the external connection terminals 2, 3 are inserted in the lower half 21. The structure of the part of the lower half in which the external connection terminals 2, 3 are inserted are similar to that of the upper half which has been explained hereinabove. Further, the positioning of components to be mounted, can be made only in the lower half, the positional accuracy can be enhanced. Further, since the external connection terminals are surely inserted in the lower half before the upper and lower halves are actuated, stable molding can be expected.

Fig. 38 is a sectional view illustrating a resin flow passage during resin-molding. That is, the guide plate 6 with positioning holes is clamped between the upper and lower halves 20, 21 of the molding tool, and the other part including the heat spreader 5 are set in the cavity 19. At this time, the gate 18 and the runner 17 are set in the lower half 21. After the parts are set in the cavity 9 in such a way, resin 7 is cast into the cavity 19 so that resin molding is completed, and accordingly, all parts are covered with the resin 7, except a part of the power supply terminals 2 and the control signal terminals, and the backside surfacce of the guide plate 6.

Next, explanation will be made of transfer-molding in such a case that movable parts are provided in the cavity to be resin-molded so as to fasten vertical terminals.

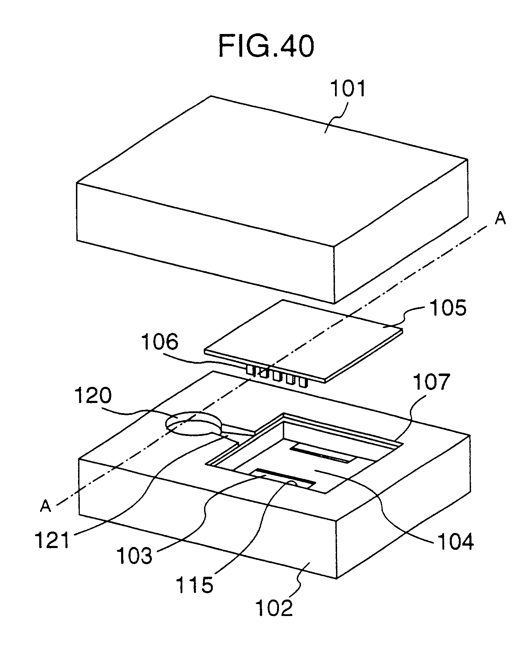

Referring to Fig. 40 which shows an example, there are shown a upper half 101, a lower half 102, and an insulating circuit board 105 incorporating vertical terminals 106 set in the molding tool. The lower half 102 is composed of a cavity 107 in which the insulating circuit board 105 is set, a pot 120 from which resin is fed into the cavity through a runner 121.

In particular, the lower half 102 according to the present invention, is provided therein with a stationary part 104 formed therein with recesses on opposite sides thereof and movable parts 103 which are moved within the recesses. The vertical terminals 106 aligned with the recesses are clamped by moving the movable parts 103. Accordingly, the movable part 103 are preferably configured such that they are fitted in the recesses of the stationary part 104 while they clamp the vertical terminals 106.

Referring to Fig. 39 is a sectional view along line A-A in Fig. 40 which is a schematic view illustrating the upper and lower halves, the insulating circuit board 105 is set in the molding tool at a predetermined position, and thereafter, the upper and lower halves are closed.

As shown in Fig. 39, the insulating circuit board 105 provided thereon with the vertical terminals 106 which are electrically connected with a semiconductor element (which is not shown) is set in the cavity 107 defined between the upper and lower halves 101 and 102 and adapted to be cast with resin, at a predetermined position. In this arrangement, a recess adapted to be fitted therein with the insulating circuit board 105 may be formed in the upper half 101 so as to position the insulating circuit board 105 (this arrangement is not shown).

Further, the insulating circuit board 105 is clamped between the upper and lower halves 101, 102 which are closed to each other.

Within the cavity 107, the terminals 106 arranged vertical to the insulating circuit board 105 are set between the stationary part 104 and the movable parts 103 in the lower half 102. Further, when the movable part 103 is moved to approach the vertical terminals 106, the vertical terminals 106 are clamped between the stationary part 104 and the movable part 103. In this arrangement, in order to stably clamp the vertical terminals between the stationary part 104 and the movable parts 103, the widths b of the stationary part 104 is set to be substantially equal to a distance a by which the vertical terminals 106 are arranged. Since these values b, a are set to be substantially equal to each other, the close contact between the vertical terminals 106 and the stationary part 104 can be enhanced, thereby it is possible to restrain occurrence of resin flashes. Further, since no excessive load is applied to the vertical terminals 103 by the movable parts 103, it is possible to restrain occurrence of inferior connection.

Thereafter, heated and molten resin is cast into the cavity 107 from the pot 120, and accordingly, the semiconductor device is transfer-molded.

Thus, with the provision of a mechanism for fastening the vertical terminals in the molding tool, stable transfer-molding can be expected without being affected by dimensional unevenness of the parts, in comparison with such an arrangement in which recesses for fitting therein with the vertical terminals are simply formed.

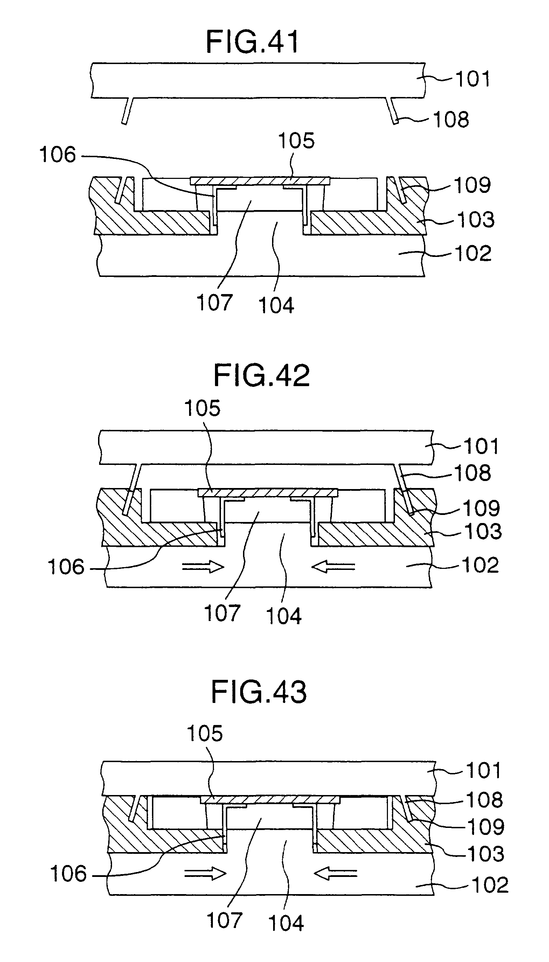

Next, explanation will be made of such a method in which the movement of the above-mentioned movable parts 103 is carried out simultaneously with the opening and closing of the upper and lower halves with the use of the motion of the latter with reference to Figs. 41 to 44 which are sectional views illustrating the molding tool in which the movable parts 103 are moved in association with the opening and closing of the upper and lower halves. It is noted that, in these figures including the subsequent figure, like reference numerals are used to denote like parts shown in Fig. 39.

Referring, at first, to Fig. 41, guide pins 108 are provided in the upper half 101, and guide holes 109 corresponding to the guide pins 108 are formed in the movable parts 103 incorporated in the lower half 102, and then, the transfer-mold is initiated. That is, the terminals 106 which are arranged, perpendicular to the insulating circuit board 105, are set so as to enter gaps between the stationary part 104 and the movable part 103. It is noted that the guide pins 108 are extended outward.

Next, as shown in Fig. 42, the upper and lower halves 101, 102 are gradually closed from a condition shown in Fig. 41, the distal ends of the guide pins 108 provided in the upper half 101 enter into the guide holes 109 formed in the lower half 102. In this condition, the parts provided in the molding tool, for clamping the vertical terminals 106 have not yet been moved.

When the molding tool is further closed so that the distance between the upper half 101 and the lower half 102 becomes shorter, the guide pins 108 gradually enter the guide holes 109.

At this time, since the guide pins 108 are fixed so as to be outward extended, the movable parts 106 for clamping the vertical terminals 106 within the molding tool, are moved inward of the cavity by the guide pins 108.

Referring to Fig. 43, the distance between the upper and lower halves 101, 102 are further shortened, and the insulating circuit board 105 is completely clamped. At this stage, the movable parts 103 in the cavities are moved simultaneously with the clamping of the insulating circuit board 105 between the upper and lower halves, and accordingly, the vertical terminals 106 provided, perpendicular to the insulating circuit board 105, are also completely clamped. Further, in a condition in which the terminals 106 which are provided, perpendicular to the insulating circuit board 105 are clamped, heated and molten resin are cast into the cavity for rein-molding.

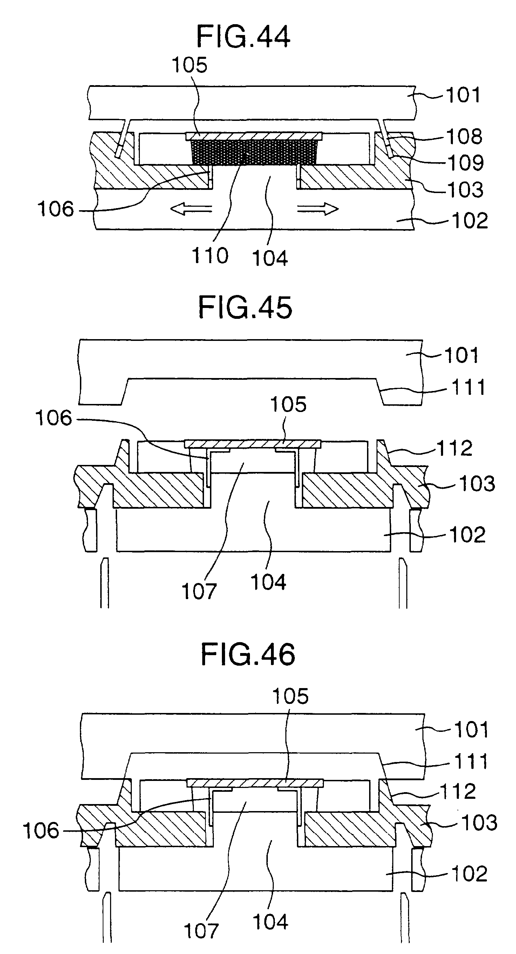

Referring to Fig. 44, after completion of the clamping of the insulating circuit board 105 and the vertical terminals, and then after molding resin 110 is fed into the cavity so as to complete the resin molding, the opening of the upper and lower molding halves 101, 102 is started. After resin-molding, simultaneously with the release of the clamping of the insulating circuit board 105 due to the opening of the upper and lower halves, the guide pins 108 are pulled out from the guide holes 109. At this time, the movable parts 103 are moved outward of the cavity by the guide pins 108, the clamping force is released from the vertical terminals 106, and accordingly, the resin-molded product can be taken out.

It is noted that in order to stably clamp the vertical terminals 106 by means of the movable part 103, the movable parts 103 have to be moved from a position shown in Fig. 42 to a position shown in Fig. 43 by a distance 11. Accordingly, the guide pins 108 are inclined so as to have a predetermined gradient, tan θ1 (= 11/h1), and therefore, the movable parts 103 can be moved by the guide pines 108 by the distance 11.

As mentioned above, in the configuration of the embodiment in which the guide pins 108 are inserted in the guide holes 109, the movable parts 103 are moved, depending upon a condition of the insertion of the guide pines 108 (in association with the opening and closing of the upper and lower halves 101, 102), so as to clamp the vertical terminals 106. Since the movable parts 103 can be moved in association with the opening and closing of the upper and lower halves 101, 102, the necessity of a mechanism for driving the movable parts can be eliminated. Accordingly, a molding machine for molding a semiconductor device can be small-sized and further, the control of the drive mechanism can be simplified.

Further, with the use of only the guide pins 108 and the guide holes 109, the clamping and releasing of the vertical terminals can be both simply made.

Next, explanation will be made of another example in which the movement of the movable parts 103 is made simultaneously with the opening and closing of the upper and lower halves 101, 102 of the molding tool with the use of the motion of the latter, with reference to Figs. 45 to 52 which are sectional views illustrating the molding tool for clamping the terminals 106 which are provided, perpendicular to the insulating circuit board 105, by means of the movable parts 103 which are moved along inclined parts 111, 112 formed respectively in the upper and lower halves 101, 102 of the molding tool.

At first, referring to Fig. 45, the upper half 101 is formed therein with a recess provided therein with the inclined parts 111 while the movable parts 103 incorporated in the lower half 102 is formed therein with the inclined parts 112 corresponding to the inclined parts 111. With this arrangement, the transfer-molding is carried out. That is, the terminals 106 provided, perpendicular to the insulating circuit board 105 are set in gaps between the stationary part 104 and the movable parts 103 in the lower half 102.

Then, referring to Fig. 46, the upper and lower halves 101, 102 are gradually closed from a condition shown in Fig. 45, and accordingly, the inclined parts 111 formed in the upper half 101 are made into contact with the inclined parts 112 formed in the movable parts 103. In this condition, the movable parts 103 have not yet been moved.

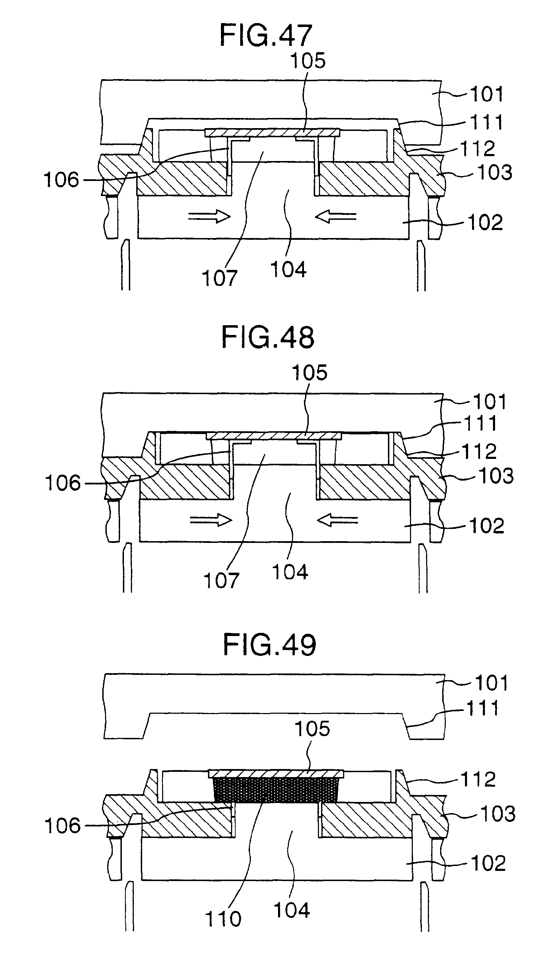

Referring to Fig. 47, the upper and lower halves 101, 102 are further closed, and accordingly, the inclined parts 112 formed in the movable parts 103 in the lower half 102 are pressed toward the stationary part 104 in the lower half, being moved inward of the cavity along the inclined parts 111 formed in the upper half 101.

Referring to Fig. 48, the upper and lower halves 101, 102 are completely closed, and accordingly, the insulating circuit board 105 are clamped between the upper and lower halves 101, 102 of the molding tool, and further, the movable parts 103 have been further moved inward of the cavity by the inclined parts 111, 112 provided in the upper and lower halves 101, 102. Further, the vertical terminals 106 provided to the insulating circuit board 105 are also clamped by the movable parts 103. In this condition, heated and molten resin is cast into the cavity for resin-molding, being held for curing in the cavity until the resin-molded product has a hardness with which the resin-molded article can be parted from the molding tool, and thereafter, the upper and lower halves 101, 102 are opened.

Referring to Fig. 49, the upper and lower halves 101, 102 are opened after resin-molding. In this condition, no clamping force is applied to the terminals provided perpendicular to the insulating circuit board from the movable parts 103, but the movable parts 103 are in a closed condition.

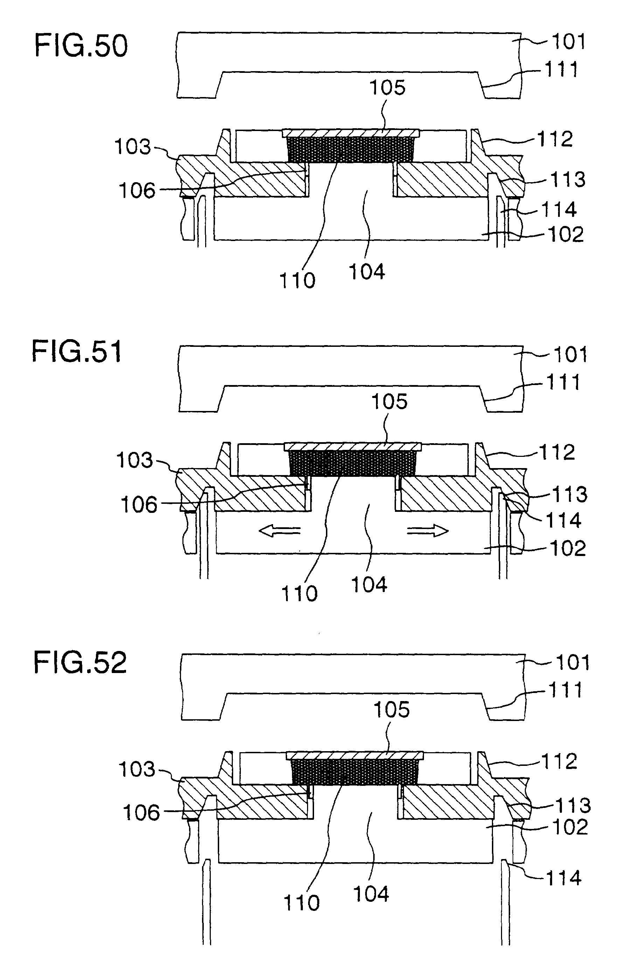

Referring to Fig. 50, the lower half 102 are lowered. Pins 114 are inserted along inclined parts 113 formed in the movable parts 103 through openings in the lower half 102 in order to release the clamping of the vertical terminals 106 by the movable parts 103. In this condition, the pins 114 are just before making contact at their inclined parts with the inclined parts 113. It is not always required that the tip end parts of the pins 114 are inclined.

Referring to Fig. 51, the pins 114 having the inclined parts are further advanced from the bottom of the lower half 102. At this stage, the inclined parts 113 of the movable parts 103 are pressed along the inclined parts of the pins 114 entering the cavity from the bottom of the lower half 102, and accordingly, the movable parts 103 are moved outward of the cavity so as to release the clamping force from the vertical terminals 106.

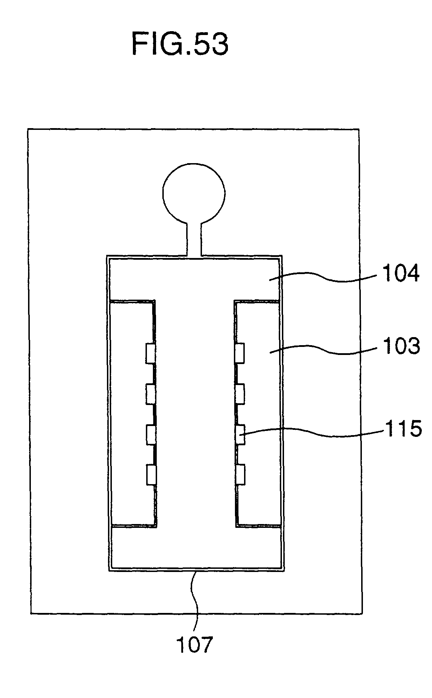

Referring to Fig. 52, the pins 114 formed therein with the inclined parts for releasing the clamping force from the vertical terminals 106 are separated from the inclined parts 113 of the movable parts 103. In this condition, the resin-molded semiconductor device can be removed from the molding tool, and accordingly, an insulating circuit board 105 can be set for the next molding.

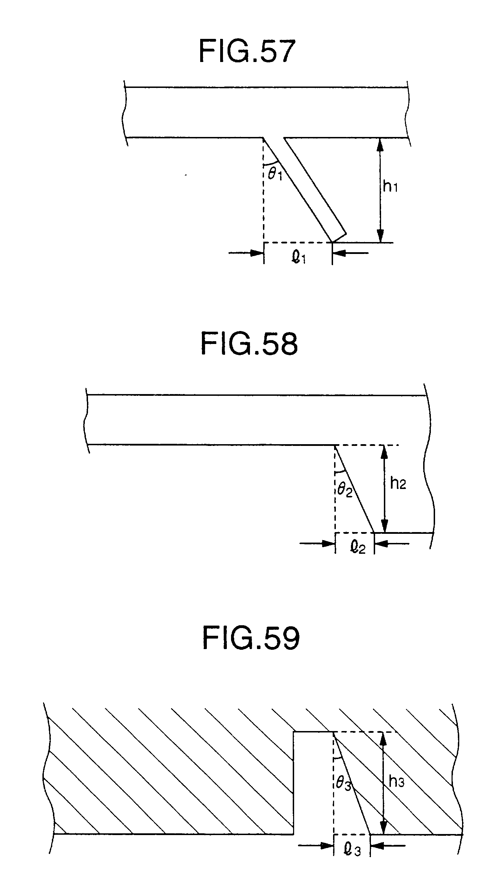

The movable parts 103 have to be moved from a position shown in Fig. 46 to a position shown in Fig. 48 by a distance 13 in order to stably clamp the vertical terminals 103 by means of the movable parts 103. Accordingly, the inclined parts 111 should have a predetermined gradient tan θ2 (=12/h2) as shown in Fig.58 in order to move the movable parts 103 by the distance 12. The same can be applied to the inclined parts 112.

Further, the movable parts 103 has to be moved from a position shown in Fig. 48 to a position shown in Fig. 50 in order to release the clamping of the vertical terminals 106 by the movable parts 103 by a distance 13. Accordingly, the inclined parts 113 should have a predetermined gradient tan θ3 (=13/h3) as shown in Fig. 58 in order to move the movable parts 103 by the distance 13. The same can be applied to the inclined parts of the pins 114.

It is noted that a plurality of semiconductor devices can continuously be transfer-molded by setting the distances 12, 13 to be equal to each other.

As mentioned above, in this embodiment according to the present invention, by engaging the inclined parts 114 formed in the upper half 101 with the inclined parts 112 formed in the lower half 102, the vertical terminals 105 can be clamped in association with the opening and closing of the upper and lower halves 101, 102 of the molding tool. Thus, if the movable parts 103 can be moved in association with the opening and closing of the upper and lower halves 101, 102, the necessity of a drive mechanism for driving the movable parts 3 can be eliminated. Thereby, it is possible not only to miniaturize a molding machine for manufacturing semiconductor devices but also to simplify the control of the drive mechanism.

Next, explanation will be made of the lower half 102 of the molding tool, in the configuration of another embodiment.

Referring to Fig. 53 illustrating a molding tool which can clamp the vertical elements provided to the insulating circuit board, and formed therein with recesses 115 having pitches and a shape which are coincident with those of the vertical terminals. That is, the lower half 102 shown in Fig. 53 has such a structure that recesses 115 formed in the movable parts 103 in the molding tool and the vertical terminals are fitted together when the vertical terminals are clamped by the movable parts in the molding tool during resin-molding. With this arrangement, the vertical terminals are fitted in the recesses 115, no leakage of the resin is caused between the terminals during the resin molding, and thereby it is possible to eliminate the necessity of the provision of dams for preventing resin from leading between the vertical terminals. Thus, the molding process can be simplified. It is noted that the recesses 15 formed in the molding tool may be formed either or both of the movable parts 103 and the stationary parts 104.

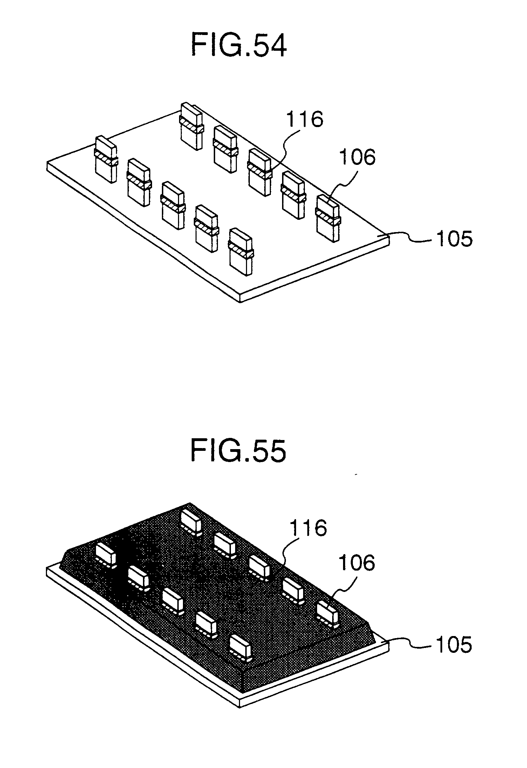

Referring to Fig. 54 which particularly shows insulators each composed of a film made of polyimide or polyethylene terephthalate, and an adhesive applied to the film, and applied to the vertical terminals 106 on the insulating circuit board 105 clamped by the movable parts in the molding tool, when the vertical terminals 106 on the insulating circuit board 105 are clamped by means of the movable parts 13 having a shape shown in Fig. 53 in the case of the insulating circuit board 105 and the vertical terminals 106 shown in Fig. 54, the insulators 116 stuck to the vertical terminals 106 block the gaps between the vertical terminals 106 and the molding tool so as to exhibit such an effect that leakage of the resin during resin-molding can be restrained. Further, since these insulators can be permanently embedded in the molded resin as shown in Fig. 55, it is not required to remove these insulators from the molding tools after resin-molding. As to the insulating film, a silicone film, in addition to a polyimide film, and a polyethylene terephthalate film as mentioned above, and further, a film in which glass cloth is impregnated with epoxy resin or phenolic resin can be used.

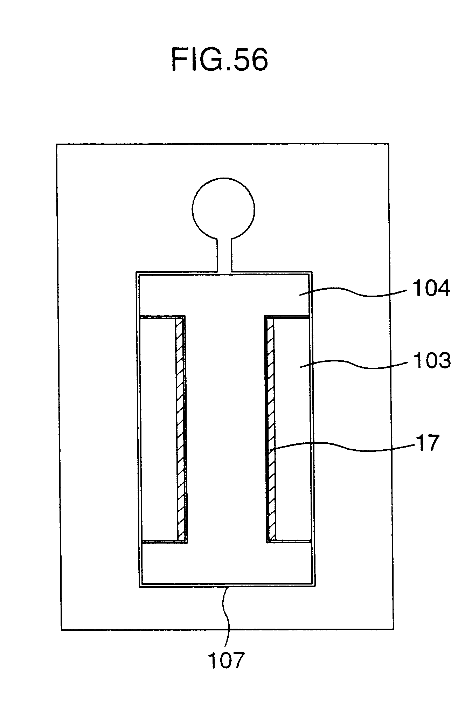

Fig. 56 shows a structure in which elastic members 117 provided in parts where the vertical terminals are clamped by the movable parts 103 in the molding tool. When the vertical terminals are clamped, the elastic members provided in the movable parts 103 deforms in compliance with the shape of the terminals so as to fill the gaps between the movable parts 103 and the terminals, thereby it is possible to prevent the leakage of resin during resin-molding.

The elastic modulus of the elastic members depends upon the size of the gaps defined between the vertical terminals and the molding tool clamping the former, and a force with which the vertical terminals are clamped. For example, if the size of the gap is about 0.1 mm as is in a conventional device for manufacturing resin-molded semiconductor devices, the elastic modulus of the elastic members may have a value in a range between 1 MPa and lOGPa.

If the elastic modulus is lower than 1 MPa, the elastic members filled in the gaps between the vertical terminals and the clamping parts would be deformed by a pressure built up in the cast resin during resin-molding, and accordingly, the cast resin possibly flows out through the gaps. Meanwhile, if the elastic modulus is higher than 10 GPa, the elastic members cannot satisfactorily be deformed during the clamping of the vertical terminals, and accordingly, it can not satisfactorily fill the gaps, resulting in leakage of resin during resin-molding. Further, the elastic members having such a high elastic modulus would cause damage to the vertical terminals so that the vertical terminals are deformed.

Thus, with the use of the elastic material having an elastic modulus in a range between 1 MPa to 10 GPa during the clamping of the vertical terminals, the resin can be prevented from leaking through the gaps between the vertical terminals and the clamping parts without damaging the vertical terminals, thereby it is possible to satisfactorily complete the resin molding.

Although the invention has been explained in the preferred embodiments in which the vertical terminals are clamped by the movable parts in the lower half, the clamping of the vertical thread can be made in the upper half by incorporating the similar function in the upper half. Further, such a function can be incorporated in both upper and lower halves. Moreover, the vertical terminals can be provided on opposite surface of the insulating circuit board as necessary.

Further, instead of the vertical terminals provided on the insulating circuit board, reed frames used in a conventional process of manufacturing semiconductors may be used by being beforehand bent.

As to the molding resin used in the present invention, there may be used resin materials which has been conventionally used for resin-molding semiconductors, such as thermosetting resin such as epoxy resin, silicone resin or polyimide resin, which is blended with a filler such as silica or aluminum oxide, a coloring agent or a pigment such as carbon black, a hardening accelerator, a coupling agent such as alkoxysilane, titanate or aluminum chelate compound, a refractory material and other additives. Further, there may be used not only the thermosetting resin materials but also thermoplastic materials with no problems.

Although the invention has been specifically explained in the form of preferred embodiments, the present invention should not be limited to these embodiments, but various modifications may be made thereto without departing the sprits and scope of the present invention.

According to the present invention, the technology of transfer-molding terminals which are vertically arranged is establshed, and accordingly, it is possible to provide a method of manufacturing a semiconductor device in which external connection terminals are arranged substantially upright and are resin-molded, and to provide a semiconductor device manufactured thereby.

Since the terminals which are arranged vertically is transfer-molded, a sufficient distance between the parts of the external connection terminals which are not molded so as to be exposed, and the heat spreader can be ensured, thereby it is possible to prevent the power transistor module from being damaged by electric discharge which would occur therebetween. In particular, this is highly effective for a large capacity power module having a high heat generating capacity so as to require a heat spreader and heat radiation fines making contact with the former.

Further, the transfer-molding is carried out with the use of the guide plate with positioning holes, thereby the manufacturing process can be automated so as to enhance the productivity, and to reduce the cost.

Further, due to the transfer-molding, it is possible to greatly enhance the reliability of moisture-resistance.

Further, according to the present invention, the method of stably manufacturing a semiconductor device in which external connection terminals are arranged substantially upright and are molded with resin, and a semiconductor device manufactured thereby can be applied to a receptor for screw fastening connection. Further, it is possible to enhance the mechanical strength of the thread part by integrally incorporating the thread part for the power supply terminals with the molded product.

## Claims

1. A method of manufacturing a semiconductor device, comprising the steps of:
arranging a electric circuit board on which an external connection terminal is arranged in a substantially vertical posture, in a cavity so as to position said external connection terminal in a recess formed in a
cavity;
clamping the external connection terminal by a movable part corresponding to the recess formed in the cavity; and
casting resin into said cavity so as to carry out transfer-molding.

2. A method of manufacturing a semiconductor device as set forth in claim 1, wherein said external connection terminal is clamped by the movable part in association with opening and closing of a molding tool defining therein said cavity.

3. A method of manufacturing a semiconductor device as set forth in claim 2, wherein a guide pin provided in said molding tool is engaged with said movable part so as to move said movable part.

4. A method of manufacturing a semiconductor device as set forth in claim 2, wherein an inclined part formed in said molding tool is engaged with said movable part so as to move said movable part.

5. A method of manufacturing a semiconductor device as set forth in claim 4, wherein a predetermined member is engaged with a part of said movable member after said transfer-molding so as to move said movable part in order to set said external connection terminal in an open condition.

6. A method of manufacturing a semiconductor device as set forth in any one of claim 1 to 5 wherein an elastic member having an elastic modulus higher than 1 MPa and lower than 10 GPa, is provided to a contact part between said external connection terminal and the recess in said cavity.
